# EUROPEAN PATENT APPLICATION

(11) **EP 4 439 981 A1**
(43) Date of publication of application: **02.10.2024**
(21) Application number: 23165924.4
(22) Date of filing: 31.03.2023
(51) Int. Cl.: H03F 3/193, H03F 3/217, H03F 3/24, H03F 3/30

(54) **AMPLIFIER CIRCUIT FOR A DIGITAL POWER AMPLIFIER**

(71) Applicant: INTEL Corporation, Santa Clara, CA 95054 (US)
(72) Inventor: DEGANI, Ofir, 22801 Nes-Ammim (IL); SHAY, Naor Roi, 7652521 Rehovot (IL)
(74) Representative: Viering, Jentschura & Partner mbB Patent- und Rechtsanwälte

(57) **Abstract**

An amplifier circuit may include a plurality of transistors connected in series, the plurality of transistors including: a first transistor of a first conductivity type, a second transistor of the first conductivity type, and a third transistor of the first conductivity type coupled to the first transistor of the first conductivity type and the second transistor of the first conductivity type, the first transistor of the first conductivity type comprising a control terminal to receive a first signal varying between a first upper voltage level and a first lower voltage level; a first transistor of a second conductivity type, a second transistor of the second conductivity type, and a third transistor of the second conductivity type coupled to the first transistor of the second conductivity type and the second transistor of the second conductivity type, the first transistor of the second conductivity type comprising a control terminal to receive a second signal varying between a second upper voltage level and a second lower voltage level; an output terminal coupled to the second transistor of the first conductivity type and the second transistor of the second conductivity type, the output terminal is configured to provide an output signal varying between the first upper voltage level and the second lower voltage level; and a feedback circuit configured to provide signals that are in phase with the output signal to a control terminal of the third transistor of the first conductivity type and to a control terminal of the third transistor of the second conductivity type.

## Description

### Technical Field

Various aspects of this disclosure relate to amplifier circuits, more specifically a circuit for a digital power amplifier.

### Background

Power amplifiers (PAs) are used in various applications to amplify electrical signals, including radio frequency (RF) circuits. Digital transmission (TX) architectures may be preferable for radio telecommunication due to their compactness, especially in terms of the die area, their scalability in advance complementary metal-oxide-semiconductors (CMOS), and improved power efficiency, in particular, due to the use of digital PAs (DPAs). One type of DPAs used in such digital TX architectures is a switched capacitor DPA (SCDPA). SCPDAs may be preferable in various operations due to their high efficiency, low distortion, and reduced size and costs compared to traditional PAs.

A SCDPA may include a switched capacitor network that may be used to convert an input signal to a high-voltage signal which may be then amplified by a PA stage. The PA stage may include one or more output transistors to provide an amplified output signal. The SCPDA may operate with a supply voltage provided by a circuit that is configured to provide a supply voltage to the SCPDA.

### Brief Description of Figures

In the drawings, like reference characters generally refer to the same parts throughout the different views. The drawings are not necessarily to scale, emphasis instead generally being placed upon illustrating the principles of the disclosure. In the following description, various aspects of the disclosure are described with reference to the following drawings, in which:
FIGs. 1 and 2 depict a general network and device architecture for wireless communications;
FIG. 3 shows an exemplary illustration of various communication elements of an apparatus for a wireless communication device;
FIG. 4 shows an exemplary illustration of a transmit path of an RF transceiver;
FIG. 5 schematically shows an example of an SCDPA;
FIG. 6 illustrates an example of an amplifier circuit with 2-level transistor stacking;
FIG. 7 illustrates an example of an amplifier circuit with 3-level transistor stacking;
FIG. 8 shows an exemplary illustration of an amplifier circuit configured to drive a capacitor of an SCDPA cell in accordance with various aspects provided herein;
FIG. 9 illustrates an example of an amplifier circuit with 4-level stacking;
FIG. 10 illustrates an example of an amplifier circuit with 4-level stacking;
FIG. 11 illustrates a voltage supply circuit in accordance with various aspects of this disclosure;
FIG. 12 shows an example of an amplifier circuit;
FIG. 13 shows a simulated representation of a waveform in an amplifier circuit;
FIG. 14 shows a simulated representation of a waveform in an amplifier circuit;
FIG. 15 shows a simulated representation of a waveform in an amplifier circuit;
FIG. 16 shows a simulated representation of a waveform in an amplifier circuit;
FIG. 17 illustrates an example of a level shifter circuit;
FIG. 18 shows an exemplary graph representing signals of a level shifter circuit;
FIG. 19A and 19B show load-pull results of an amplifier circuit with 4-level stacking provided in accordance with various aspects herein.

### Description

PAs may be used in RF circuits to provide amplification to communication signals. In DTX architectures, PAs may be employed by DPAs such as SCDPAs. An SCDPA may include a switched capacitor network that is configured to convert an input signal to a high-voltage, lowcurrent signal. The switched capacitor network may include multiple capacitors and switches that may be selectively controlled to charge and discharge the capacitors. Through control of charging and discharging the capacitors, the output signal may be provided at a desired degree. A control circuit (e.g. a digital signal processor (DSP)) may be employed for controlling the timing and sequencing of switches. The output of the SCDPA may be provided to the next component/circuit (e.g. a matching network, an antenna interface, an antenna structure).

Conventionally, a SCDPA may be implemented by a segmentation of an array including multiple cells. Each cell may include a capacitor, one or more logic for activating/deactivating the cell, and an inverter for driving the capacitor. The inverter may include transistors (e.g. field effect transistors (FETs)) configured to drive the capacitor. Due to certain limitations that the transistors are capable to handle, in particular within various types of limitations, such as limitations associated with the type of the transistors or size of the transistors, desired amplification may be affected due to low supply voltage in SCDPA cells.

To address the above-mentioned issues, namely for the purpose of obtaining desired output power from a SCDPA, various techniques have been proposed. Such techniques may include increasing the number of cells in the SCPDA and combining cells for the desired output power, which may result in an increase in the complexity of the SCDPA, costs, in particular costs associated with the size of the SCDPA, and design challenges. Alternatively, the supply voltage for the cells may have been increased, which may result in additional component stress on the inverters in a traditional SCDPA layout.

Various aspects are provided in the disclosure, which may help to overcome the above-mentioned problem associated with obtaining desired output power from the SCDPA in an efficient way. Aspects may include providing an amplifier circuit configured to provide an output signal from an input signal, the output signal being at a desired output power, which the amplifier circuit may include a circuit configured to provide feedback to inner transistors based on the output signal. Such a circuit may be a feedback circuit. Through aspects provided herein, the supply voltage of the SCDPA may be increased without building up stress on the inverter components due to increased supply voltage. The increased supply voltage may cause an increase in the output power of the SCDPA compared to traditional SCDPAs.

It is to be noted herein, the term "amplifier circuit" used herein may refer to a circuitry that is configured to receive an input digital signal and to provide an output signal at a desired power level, that is higher than the power of the input digital signal, for RF transmission in a DTX architecture by referencing to DPAs replacing analog PAs. Such a circuitry may be referred to as a Digital to Power Converter (DPC), pointing to its aspects associated with conversion of DC energy to AC through controlled capacitive divider. Such a circuitry may further be referred to as an RF digital to analog converter (RF-CDAC).

In some aspects, an amplifier circuit provided herein may include multiple transistor stacks. A transistor stack may refer to a series of transistors connected in a particular configuration (e.g. a cascade configuration, a cascode configuration). A transistor stack may include several identical or different transistors that are connected in series. In some examples, the amplifier circuit may include two transistor stacks, each transistor stack including an N number of transistors of a particular conductivity type that is different from the other transistor stack, N being an integer greater than 2. In some examples, N may be 3, or 4, or 5, or 6, or 7. Exemplarily, the amplifier circuit may include a first transistor stack including N (e.g. 4) p-type transistors connected in series (i.e. a drain terminal of one transistor is connected to a source terminal of another transistor) and a second transistor stack including N (e.g. 4) n-type transistors connected in series. One transistor of the first transistor stack may be connected to a further transistor of the second transistor stack. Although transistor stacking may appear to increase the on-resistance of the amplifier circuit (Ron), there is net efficiency improvement due to lower currents and improvement in a measure of power loss due to the Ron (I²Ron) loss and even in supply network current-resistance (IR) drop and losses.

Although the disclosure is designed to provide various aspects by providing examples according to an amplifier circuit including p-type transistors and n-type transistors, which the terminology used herein may correspond to field effect transistors (FETs), in particular via p-channel metal oxide-semiconductors (PMOS) and n-channel metal oxide-semiconductors (NMOS) for the sake of brevity, the skilled person would recognize that aspects disclosed herein are related to any type of transistors of a first conductivity type (e.g. a PMOS) and a second conductivity type (e.g. NMOS) correspondingly a complementary metal oxide-semiconductors (CMOS), which may be realized through the use of other types of transistors (FET or non-FET), such as junction FETs (JFETs), metal-semiconductor FETs (MESFETs), a Fin FET (FinFET), high-electron-mobility transistors (HEMT), bipolar junction transistors (BJTs), insulated-gate bipolar transistors (IGBTs), etc.

In some aspects provided herein, the amplifier circuit may include a feedback circuit. The feedback circuit may provide a signal to control output voltages (e.g. drain-source voltage or emitter-collector voltage) of one or more transistors of the amplifier circuit based on an output signal of the amplifier circuit. The feedback circuit may include a capacitive feedback circuit. A capacitive feedback circuit coupled to an output terminal of the amplifier circuit may provide a signal that is in-phase with the output signal of the amplifier circuit. The voltage of the provided signal may be proportional to the voltage of the output signal. The provided signal may be used to drive one or more inner transistors of the amplifier circuit through their control terminals (e.g. gate terminal or bias terminal).

In some aspects provided herein, the amplifier circuit may include a keeper circuit. The keeper circuit may maintain voltage levels between terminals of one or more transistors within a desired range, in particular the voltage levels between the output terminals of the one or more transistors (e.g. drain-source voltages). Within this context, the disclosure may use the term "signal swing", "voltage swing", or sometimes "swing", which may refer to the variation in the voltage level of an electric signal over time. Correspondingly, the voltage level of an electric signal over time may refer to a variation between an upper voltage level and a lower voltage level. The upper voltage level and the lower voltage level may represent the highest voltage and the lowest voltage configured for the signal swing respectively. In other words, the voltage signal may refer to the peak-to-peak amplitude of the digital signal. Accordingly, a keeper circuit may maintain voltage swings between two terminals (e.g. between the source terminal of a transistor and the drain terminal of the transistor) to be within desired voltage range or ranges. A keeper circuit may include one or more pull-up components (e.g. a pull-up transistor) to maintain an upper voltage level at a node. The keeper circuit may further include one or more pull-down components (e.g. a pull-down transistor) to maintain a lower voltage level at a node.

In some aspects, the output terminal of the amplifier circuit may be connected to a capacitor. The amplifier circuit may be connected to a voltage supplier to provide supply voltage to the transistors. In some examples, the amplifier circuit may include the voltage supplier. In some aspects, the amplifier circuit may further include a first signal input and a second signal input to receive input signals. The amplifier circuit may provide an amplified signal from the output terminal. In some aspects, the amplifier circuit and the connected capacitor may form a circuit of an SCDPA cell. The SCDPA cell may further include a logic configured to control the amplifier circuit. An SCDPA may include a plurality of amplifier circuits as provided herein and capacitors coupled to the amplifier circuits respectively.

The apparatuses and methods of this disclosure may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a Global System for Mobile Communications ("GSM") radio communication technology, a General Packet Radio Service ("GPRS") radio communication technology, an Enhanced Data Rates for GSM Evolution ("EDGE") radio communication technology, and/or a Third Generation Partnership Project ("3GPP") radio communication technology, for example Universal Mobile Telecommunications System ("UMTS"), Freedom of Multimedia Access ("FOMA"), 3GPP Long Term Evolution ("LTE"), 3GPP Long Term Evolution Advanced ("LTE Advanced"), Code division multiple access 2000 ("CDMA2000"), Cellular Digital Packet Data ("CDPD"), Mobitex, Third Generation (3G), Circuit Switched Data ("CSD"), High-Speed Circuit-Switched Data ("HSCSD"), Universal Mobile Telecommunications System ("Third Generation") ("UMTS (3G)"), Wideband Code Division Multiple Access (Universal Mobile Telecommunications System) ("W-CDMA (UMTS)"), High Speed Packet Access ("HSPA"), High-Speed Downlink Packet Access ("HSDPA"), High-Speed Uplink Packet Access ("HSUPA"), High Speed Packet Access Plus ("HSPA+"), Universal Mobile Telecommunications System-Time-Division Duplex ("UMTS-TDD"), Time Division-Code Division Multiple Access ("TD-CDMA"), Time Division-Synchronous Code Division Multiple Access ("TD-CDMA"), 3rd Generation Partnership Project Release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10), 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 5G, 3GPP LTE Extra, LTE-Advanced Pro, LTE Licensed-Assisted Access ("LAA"), MuLTEfire, UMTS Terrestrial Radio Access ("UTRA"), Evolved UMTS Terrestrial Radio Access ("E-UTRA"), Long Term Evolution Advanced (4th Generation) ("LTE Advanced (4G)"), cdmaOne ("2G"), Code division multiple access 2000 (Third generation) ("CDMA2000 (3G)"), Evolution-Data Optimized or Evolution-Data Only ("EV-DO"), Advanced Mobile Phone System (1st Generation) ("AMPS (1G)"), Total Access Communication arrangement/Extended Total Access Communication arrangement ("TACS/ETACS"), Digital AMPS (2nd Generation) ("D-AMPS (2G)"), Push-to-talk ("PTT"), Mobile Telephone System ("MTS"), Improved Mobile Telephone System ("IMTS"), Advanced Mobile Telephone System ("AMTS"), OLT (Norwegian for Offentlig Landmobil Telefoni, Public Land Mobile Telephony), MTD (Swedish abbreviation for Mobiltelefonisystem D, or Mobile telephony system D), Public Automated Land Mobile ("Autotel/PALM"), ARP (Finnish for Autoradiopuhelin, "car radio phone"), NMT (Nordic Mobile Telephony), High capacity version of NTT (Nippon Telegraph and Telephone) ("Hicap"), Cellular Digital Packet Data ("CDPD"), Mobitex, DataTAC, Integrated Digital Enhanced Network ("iDEN"), Personal Digital Cellular ("PDC"), Circuit Switched Data ("CSD"), Personal Handy-phone System ("PHS"), Wideband Integrated Digital Enhanced Network ("WiDEN"), iBurst, Unlicensed Mobile Access ("UMA"), also referred to as also referred to as 3GPP Generic Access Network, or GAN standard), Zigbee, Bluetooth^{®}, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.1 1p and other) Vehicle-to-Vehicle ("V2V") and Vehicle-to-X ("V2X") and Vehicle-to-Infrastructure ("V2I") and Infrastructure-to-Vehicle ("12V") communication technologies, 3GPP cellular V2X, DSRC (Dedicated Short Range Communications) communication arrangements such as Intelligent-Transport-Systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = Licensed Shared Access in 2.3-2.4 GHz, 3.4-3.6 GHz, 3.6-3.8 GHz and further frequencies and SAS = Spectrum Access System in 3.55-3.7 GHz and further frequencies), and may use various spectrum bands including, but not limited to, IMT (International Mobile Telecommunications) spectrum (including 450-470 MHz, 790-960 MHz, 1710-2025 MHz, 2110-2200 MHz, 2300-2400 MHz, 2500-2690 MHz, 698-790 MHz, 610-790 MHz, 3400-3600 MHz, etc., where some bands may be limited to specific region(s) and/or countries), IMT-advanced spectrum, IMT-2020 spectrum (expected to include 3600-3800 MHz, 3.5 GHz bands, 700 MHz bands, bands within the 24.25-86 GHz range, etc.), spectrum made available under FCC's "Spectrum Frontier" 5G initiative (including 27.5-28.35 GHz, 29.1-29.25 GHz, 31-31.3 GHz, 37-38.6 GHz, 38.6-40 GHz, 42-42.5 GHz, 57-64 GHz, 64-71 GHz, 71-76 GHz, 81-86 GHz and 92-94 GHz, etc.), the ITS (Intelligent Transport Systems) band of 5.9 GHz (typically 5.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 70.2 GHz-71 GHz band, any band between 65.88 GHz and 71 GHz, bands currently allocated to automotive radar applications such as 76-81 GHz, and future bands including 94-300 GHz and above. Furthermore, the apparatuses and methods described herein can also employ radio communication technologies on a secondary basis on bands such as the TV White Space bands (typically below 790 MHz) where e.g. the 400 MHz and 700 MHz bands are prospective candidates. Besides cellular applications, specific applications for vertical markets may be addressed such as PMSE (Program Making and Special Events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier-1 users, followed by tier-2, then tier-3, etc. users, etc. The apparatuses and methods described herein can also use radio communication technologies with different Single Carrier or OFDM flavors (CP-OFDM, SC-FDMA, SC-OFDM, filter bankbased multicarrier (FBMC), OFDMA, etc.) and e.g. 3GPP NR (New Radio), which can include allocating the OFDM carrier data bit vectors to the corresponding symbol resources.

For purposes of this disclosure, radio communication technologies may be classified as one of a Short Range radio communication technology or Cellular Wide Area radio communication technology. Short Range radio communication technologies may include Bluetooth, WLAN (e.g., according to any IEEE 802.11 standard), and other similar radio communication technologies. Cellular Wide Area radio communication technologies may include Global System for Mobile Communications ("GSM"), Code Division Multiple Access 2000 ("CDMA2000"), Universal Mobile Telecommunications System ("UMTS"), Long Term Evolution ("LTE"), General Packet Radio Service ("GPRS"), Evolution-Data Optimized ("EV-DO"), Enhanced Data Rates for GSM Evolution ("EDGE"), High Speed Packet Access (HSPA; including High Speed Downlink Packet Access ("HSDPA"), High Speed Uplink Packet Access ("HSUPA"), HSDPA Plus ("HSDPA+"), and HSUPA Plus ("HSUPA+")), Worldwide Interoperability for Microwave Access ("WiMax") (e.g., according to an IEEE 802.16 radio communication standard, e.g., WiMax fixed or WiMax mobile), etc., and other similar radio communication technologies. Cellular Wide Area radio communication technologies also include "small cells" of such technologies, such as microcells, femtocells, and picocells. Cellular Wide Area radio communication technologies may be generally referred to herein as "cellular" communication technologies.

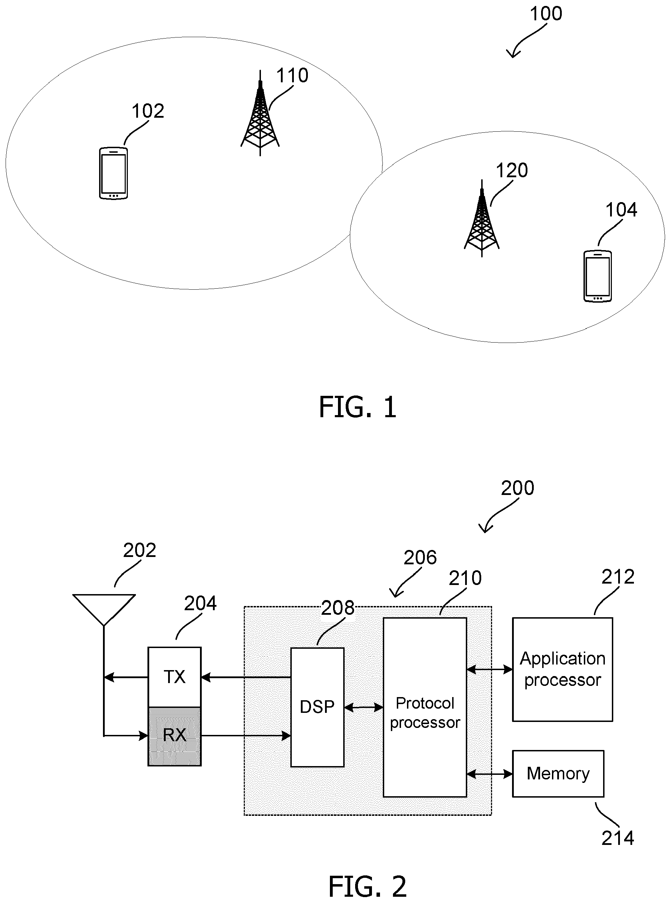

FIGs. 1 and 2 depict a general network and device architecture for wireless communications. In particular, FIG. 1 shows exemplary radio communication network 100 according to some aspects, which may include terminal devices 102 and 104 and network access nodes 110 and 120. Radio communication network 100 may communicate with terminal devices 102 and 104 via network access nodes 110 and 120 over a radio access network. Although certain examples described herein may refer to a particular radio access network context (e.g., LTE, UMTS, GSM, other 3rd Generation Partnership Project (3GPP) networks, WLAN/WiFi, Bluetooth, 5GNR, mmWave, etc.), these examples are demonstrative and may therefore be readily applied to any other type or configuration of radio access network. The number of network access nodes and terminal devices in radio communication network 100 is exemplary and is scalable to any amount.

In an exemplary cellular context, network access nodes 110 and 120 may be base stations (e.g., eNodeBs, NodeBs, Base Transceiver Stations (BTSs), gNodeBs, or any other type of base station), while terminal devices 102 and 104 may be cellular terminal devices (e.g., Mobile Stations (MSs), User Equipments (UEs), or any type of cellular terminal device). Network access nodes 110 and 120 may therefore interface (e.g., via backhaul interfaces) with a cellular core network such as an Evolved Packet Core (EPC, for LTE), Core Network (CN, for UMTS), or other cellular core networks, which may also be considered part of radio communication network 100. The cellular core network may interface with one or more external data networks. In an exemplary short-range context, network access node 110 and 120 may be access points (APs, e.g., WLAN or WiFi APs), while terminal device 102 and 104 may be short range terminal devices (e.g., stations (STAs)). Network access nodes 110 and 120 may interface (e.g., via an internal or external router) with one or more external data networks. Network access nodes 110 and 120 and terminal devices 102 and 104 may include one or multiple transmission/reception points (TRPs).

Network access nodes 110 and 120 (and, optionally, other network access nodes of radio communication network 100 not explicitly shown in FIG. 1) may accordingly provide a radio access network to terminal devices 102 and 104 (and, optionally, other terminal devices of radio communication network 100 not explicitly shown in FIG. 1). In an exemplary cellular context, the radio access network provided by network access nodes 110 and 120 may enable terminal devices 102 and 104 to wirelessly access the core network via radio communications. The core network may provide switching, routing, and transmission, for traffic data related to terminal devices 102 and 104, and may further provide access to various internal data networks (e.g., control nodes, routing nodes that transfer information between other terminal devices on radio communication network 100, etc.) and external data networks (e.g., data networks providing voice, text, multimedia (audio, video, image), and other Internet and application data). In an exemplary short-range context, the radio access network provided by network access nodes 110 and 120 may provide access to internal data networks (e.g., for transferring data between terminal devices connected to radio communication network 100) and external data networks (e.g., data networks providing voice, text, multimedia (audio, video, image), and other Internet and application data).

The radio access network and core network (if applicable, such as for a cellular context) of radio communication network 100 may be governed by communication protocols that can vary depending on the specifics of radio communication network 100. Such communication protocols may define the scheduling, formatting, and routing of both user and control data traffic through radio communication network 100, which includes the transmission and reception of such data through both the radio access and core network domains of radio communication network 100. Accordingly, terminal devices 102 and 104 and network access nodes 110 and 120 may follow the defined communication protocols to transmit and receive data over the radio access network domain of radio communication network 100, while the core network may follow the defined communication protocols to route data within and outside of the core network. Exemplary communication protocols include LTE, UMTS, GSM, WiMAX, Bluetooth, WiFi, mmWave, etc., any of which may be applicable to radio communication network 100.

FIG. 2 shows an exemplary internal configuration of a communication device according to various aspects provided in this disclosure. The communication device may include various aspects of network access nodes 110, 120 or various aspects of a terminal device 102 as well. The communication device 200 may include antenna system 202, radio frequency (RF) transceiver 204, baseband modem 206 (including digital signal processor 208 and protocol controller 210), application processor 212, and memory 214. Although not explicitly shown in FIG. 2, in some aspects communication device 200 may include one or more additional hardware and/or software components, such as processors/microprocessors, controllers/microcontrollers, other specialty or generic hardware/processors/circuits, peripheral device(s), memory, power supply, external device interface(s), subscriber identity module(s) (SIMs), user input/output devices (display(s), keypad(s), touchscreen(s), speaker(s), external button(s), camera(s), microphone(s), etc.), or other related components.

Communication device 200 may transmit and receive radio signals on one or more radio access networks. Baseband modem 206 may direct such communication functionality of communication device 200 according to the communication protocols associated with each radio access network, and may execute control over antenna system 202 and RF transceiver 204 to transmit and receive radio signals according to the formatting and scheduling parameters defined by each communication protocol. Although various practical designs may include separate communication components for each supported radio communication technology (e.g., a separate antenna, RF transceiver, digital signal processor, and controller), for purposes of conciseness the configuration of communication device 200 shown in FIG. 2 depicts only a single instance of such components.

Communication device 200 may transmit and receive wireless signals with antenna system 202. Antenna system 202 may be a single antenna or may include one or more antenna arrays that each include multiple antenna elements. For example, antenna system 202 may include an antenna array at the top of communication device 200 and a second antenna array at the bottom of communication device 200. In some aspects, antenna system 202 may additionally include analog antenna combination and/or beamforming circuitry.

In the receive (RX) path, RF transceiver 204 may receive analog radio frequency signals from antenna system 202 and perform analog and digital RF front-end processing on the analog radio frequency signals to produce digital baseband samples (e.g., In-Phase/Quadrature (IQ) samples) to provide to baseband modem 206. RF transceiver 204 may include analog and digital reception components including amplifiers (e.g., Low Noise Amplifiers (LNAs)), filters, RF demodulators (e.g., RF IQ demodulators)), and analog-to-digital converters (ADCs), which RF transceiver 204 may utilize to convert the received radio frequency signals to digital baseband samples. In the transmit (TX) path, RF transceiver 204 may receive digital baseband samples from baseband modem 206 and perform analog and digital RF front-end processing on the digital baseband samples to produce analog radio frequency signals to provide to antenna system 202 for wireless transmission. RF transceiver 204 may thus include analog and digital transmission components including amplifiers (e.g., Power Amplifiers (PAs), filters, RF modulators (e.g., RF IQ modulators), and digital-to-analog converters (DACs), which RF transceiver 204 may utilize to mix the digital baseband samples received from baseband modem 206 and produce the analog radio frequency signals for wireless transmission by antenna system 202. In some aspects baseband modem 206 may control the radio transmission and reception of RF transceiver 204, including specifying the transmit and receive radio frequencies for operation of RF transceiver 204. In some aspects, one of the amplifiers may include an amplifier circuit provided herein.

As shown in FIG. 2, baseband modem 206 may include digital signal processor 208, which may perform physical layer (PHY, Layer 1) transmission and reception processing to, in the transmit path, prepare outgoing transmit data provided by protocol controller 210 for transmission via RF transceiver 204, and, in the receive path, prepare incoming received data provided by RF transceiver 204 for processing by protocol controller 210. Digital signal processor 208 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancelation, and any other physical layer processing functions. Digital signal processor 208 may be structurally realized as hardware components (e.g., as one or more digitally-configured hardware circuits or FPGAs), software-defined components (e.g., one or more processors configured to execute program code defining arithmetic, control, and I/O instructions (e.g., software and/or firmware) stored in a non-transitory computer-readable storage medium), or as a combination of hardware and software components. In some aspects, digital signal processor 208 may include one or more processors configured to retrieve and execute program code that defines control and processing logic for physical layer processing operations. In some aspects, digital signal processor 208 may execute processing functions with software via the execution of executable instructions. In some aspects, digital signal processor 208 may include one or more dedicated hardware circuits (e.g., ASICs, FPGAs, and other hardware) that are digitally configured to specific execute processing functions, where the one or more processors of digital signal processor 208 may offload certain processing tasks to these dedicated hardware circuits, which are known as hardware accelerators. Exemplary hardware accelerators can include Fast Fourier Transform (FFT) circuits and encoder/decoder circuits. In some aspects, the processor and hardware accelerator components of digital signal processor 208 may be realized as a coupled integrated circuit.

Communication device 200 may be configured to operate according to one or more radio communication technologies. Digital signal processor 208 may be responsible for lower-layer processing functions (e.g., Layer 1/PHY) of the radio communication technologies, while protocol controller 210 may be responsible for upper-layer protocol stack functions (e.g., Data Link Layer/Layer 2 and/or Network Layer/Layer 3). Protocol controller 210 may thus be responsible for controlling the radio communication components of communication device 200 (antenna system 202, RF transceiver 204, and digital signal processor 208) in accordance with the communication protocols of each supported radio communication technology, and accordingly may represent the Access Stratum and Non-Access Stratum (NAS) (also encompassing Layer 2 and Layer 3) of each supported radio communication technology. Protocol controller 210 may be structurally embodied as a protocol processor configured to execute protocol stack software (retrieved from a controller memory) and subsequently control the radio communication components of communication device 200 to transmit and receive communication signals in accordance with the corresponding protocol stack control logic defined in the protocol software. Protocol controller 210 may include one or more processors configured to retrieve and execute program code that defines the upper-layer protocol stack logic for one or more radio communication technologies, which can include Data Link Layer/Layer 2 and Network Layer/Layer 3 functions. Protocol controller 210 may be configured to perform both user-plane and control-plane functions to facilitate the transfer of application layer data to and from radio communication device 200 according to the specific protocols of the supported radio communication technology. User-plane functions can include header compression and encapsulation, security, error checking and correction, channel multiplexing, scheduling and priority, while control-plane functions may include setup and maintenance of radio bearers. The program code retrieved and executed by protocol controller 210 may include executable instructions that define the logic of such functions.

Communication device 200 may also include application processor 212 and memory 214. Application processor 212 may be a CPU, and may be configured to handle the layers above the protocol stack, including the transport and application layers. Application processor 212 may be configured to execute various applications and/or programs of communication device 200 at an application layer of communication device 200, such as an operating system (OS), a user interface (UI) for supporting user interaction with communication device 200, and/or various user applications. The application processor may interface with baseband modem 206 and act as a source (in the transmit path) and a sink (in the receive path) for user data, such as voice data, audio/video/image data, messaging data, application data, basic Internet/web access data, etc. In the transmit path, protocol controller 210 may therefore receive and process outgoing data provided by application processor 212 according to the layer-specific functions of the protocol stack, and provide the resulting data to digital signal processor 208. Digital signal processor 208 may then perform physical layer processing on the received data to produce digital baseband samples, which digital signal processor may provide to RF transceiver 204. RF transceiver 204 may then process the digital baseband samples to convert the digital baseband samples to analog RF signals, which RF transceiver 204 may wirelessly transmit via antenna system 202. In the receive path, RF transceiver 204 may receive analog RF signals from antenna system 202 and process the analog RF signals to obtain digital baseband samples. RF transceiver 204 may provide the digital baseband samples to digital signal processor 208, which may perform physical layer processing on the digital baseband samples. Digital signal processor 208 may then provide the resulting data to protocol controller 210, which may process the resulting data according to the layer-specific functions of the protocol stack and provide the resulting incoming data to application processor 212. Application processor 212 may then handle the incoming data at the application layer, which can include execution of one or more application programs with the data and/or presentation of the data to a user via a user interface.

Memory 214 may embody a memory component of communication device 200, such as a hard drive or another such permanent memory device. Although not explicitly depicted in FIG. 2, the various other components of communication device 200 shown in FIG. 2 may additionally each include integrated permanent and non-permanent memory components, such as for storing software program code, buffering data, etc.

In accordance with some radio communication networks, terminal devices 102 and 104 may execute mobility procedures to connect to, disconnect from, and switch between available network access nodes of the radio access network of radio communication network 100. As each network access node of radio communication network 100 may have a specific coverage area, terminal devices 102 and 104 may be configured to select and re-select \ available network access nodes in order to maintain a strong radio access connection with the radio access network of radio communication network 100. For example, terminal device 102 may establish a radio access connection with network access node 110 while terminal device 104 may establish a radio access connection with network access node 112. In the event that the current radio access connection degrades, terminal devices 102 or 104 may seek a new radio access connection with another network access node of radio communication network 100; for example, terminal device 104 may move from the coverage area of network access node 112 into the coverage area of network access node 110. As a result, the radio access connection with network access node 112 may degrade, which terminal device 104 may detect via radio measurements such as signal strength or signal quality measurements of network access node 112. Depending on the mobility procedures defined in the appropriate network protocols for radio communication network 100, terminal device 104 may seek a new radio access connection (which may be, for example, triggered at terminal device 104 or by the radio access network), such as by performing radio measurements on neighboring network access nodes to determine whether any neighboring network access nodes can provide a suitable radio access connection. As terminal device 104 may have moved into the coverage area of network access node 110, terminal device 104 may identify network access node 110 (which may be selected by terminal device 104 or selected by the radio access network) and transfer to a new radio access connection with network access node 110. Such mobility procedures, including radio measurements, cell selection/reselection, and handover are established in the various network protocols and may be employed by terminal devices and the radio access network in order to maintain strong radio access connections between each terminal device and the radio access network across any number of different radio access network scenarios.

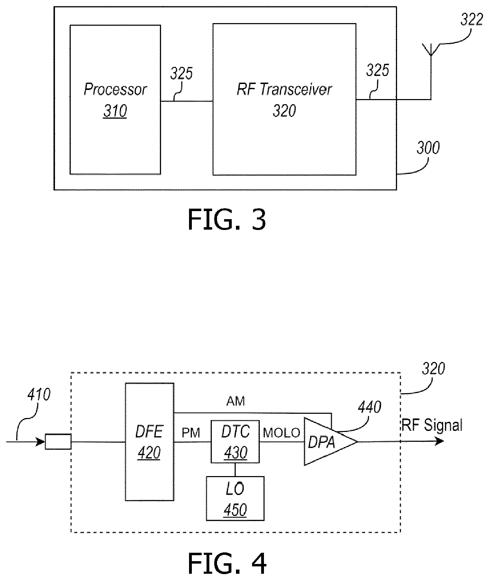

FIG. 3 shows an exemplary illustration of various communication elements of an apparatus for a wireless communication device (e.g. the communication device 200). The apparatus 300 may include processing circuitry 310 (e.g. the baseband modem 206, the application processor 212) that may direct and manage communication operations of the apparatus 300 according to one or more radio communication protocols, and may control transmission/reception of communication signals over at least one or more antenna 322 via an RF transceiver 320. The processing circuitry 310 may include an interface to the RF transceiver 320. The RF transceiver 320 may include at least one RF-chain to process the communication signals associated with the antenna 322 respectively. The apparatus 300 may include the antenna 322, or the apparatus 300 may include an antenna interface couplable to the antenna 322. It is to be noted that the apparatus 300 is depicted as being couplable to the antenna 322, but the apparatus 300 may be couplable to a plurality of antennas, and thereby the RF transceiver 320 may include a plurality of RF-chains, each RF-chain may process communication signals for a respective antenna. The apparatus 300 may transmit and receive radio communication signals with the antenna 322. The apparatus 300 may act as an RF transmitter (e.g. RF transmit circuit) to transmit radio communication signals and it may also act as an RF receiver (e.g. RF receive circuit) to receive radio communication signals.

The processing circuitry 310 may include, or may be implemented, partially or entirely, by circuit and/or logic, e.g., a processor including circuit and/or logic, a memory circuit and/or a logic, which may be configured to manage radio communication operations. The processing circuitry 310 may be configured to communicate with an external main processor (e.g. a host processor, a central processing unit (CPU), a system on chip (SoC)) of the wireless communication device including the apparatus 300 via a designated interface that is coupled to the main processor. In some examples, the processing circuitry 310 may be the main processor of the wireless communication device. The processing circuitry 310 may also access the main memory of the respective wireless communication device via the designated interface. The processing circuitry 310 may further include an interface to the RF transceiver 320.

The processing circuitry 310 may include a digital signal processor (e.g. the digital signal processor 208). The digital signal processor 208 may be configured to perform one or more of error detection, forward error correction encoding/decoding, channel coding, and interleaving, channel modulation/demodulation, physical channel mapping, radio measurement and search, frequency and time synchronization, antenna diversity processing, power control, and weighting, rate matching/de-matching, retransmission processing, interference cancelation, and any other physical layer processing functions.

The processing circuitry 310 may include a modem configured to process baseband signals received from/sent to the antenna 322 via a communication path 325 including a respective RF chain. In various examples, the interface to the RF transceiver 320 of the processing circuitry 310 may be configured to couple the processing circuitry 310 to the communication path 325. Accordingly, the processing circuitry 310 may include Media-Access Control (MAC) circuit and/or logic, Physical Layer (PHY) circuit and/or logic, baseband (BB) circuit and/or logic, a BB processor, a BB memory, Application Processor (AP) circuit and/or logic, an AP processor, an AP memory, and/or any other circuit and/or logic. By way of example, the processing circuitry 310 can perform baseband processing on the digital baseband signals to recover data included in wireless data transmissions.

The processing circuitry 310 may control and/or arbitrate transmit and/or receive functions of the apparatus 300, and perform one or more baseband processing functions (e.g., media access control (MAC), encoding/decoding, modulation/demodulation, data symbol mapping, error correction, etc.). The processing circuitry 310 may be configured to provide control functions to the RF transceiver 320 (e.g. to the RF-chain to control and/or arbitrate transmitting and/or receiving radio communication signals). In aspects, functions of processing circuitry 310 can be implemented in software and/or firmware executing on one or more suitable programmable processors, and may be implemented, for example, in a field programmable gate array (FPGA), application specific integrated circuit (ASIC), etc. In various examples, the interface to the RF transceiver 320 of the processing circuitry 310 may be configured to couple processing circuitry to the RF transceiver to provide communication in-between.

The RF transceiver 320 may provide RF processing of communication signals conveyed via a communication path within a respective RF chain to transmit radio communication signals via a respective antenna based on signals (e.g. baseband communication signals, digital signals) received from the processing circuitry 310 over the communication path. The RF transceiver 320 may provide RF processing of communication signals conveyed via the communication path 325 to receive radio communication signals via the antenna 322 and provide signals to the processing circuitry 310 over the communication path 325. The processing circuity 310 may be configured to control operations of the RF transceiver 320. The RF transceiver 320 may include a receive path to provide RF processing to receive radio communication signals received from the antenna 322, and a transmit path to provide RF processing to transmit radio communication signals transmitted via the antenna 322.

In a receive (RX) path, The RF transceiver 320 may receive analog radio frequency signals from the antenna 322 via the communication paths 325 and perform analog and digital RF front-end processing on the analog radio frequency signals to produce digital baseband samples (e.g., In-Phase/Quadrature (IQ) samples) to provide to the processing circuitry 310. In various examples, RF transceiver 320 may include two RF-chains per antenna element, each RF-chain may be designated for a particular polarization. The RF transceiver 320 may include analog and digital reception components including amplifiers (e.g., Low Noise Amplifiers (LNAs)), filters, RF demodulators (e.g., RF IQ demodulators)), and analog-to-digital converters (ADCs), which RF transceiver 320 may utilize to convert the received radio frequency signals to digital baseband samples.

In a transmit (TX) path, the RF transceiver 320 may receive digital baseband samples from processing circuitry 310 and perform analog and digital RF front-end processing on the digital baseband samples to produce analog radio frequency signals to be provided to the antenna 322 via the communication paths 325 for radio transmission. The RF transceiver 320 may thus include analog and digital transmission components including amplifiers (e.g., Power Amplifiers (PAs), filters, RF modulators (e.g., RF IQ modulators), and digital-to-analog converters (DACs), which the RF transceiver 320 may utilize to mix the digital baseband samples received from processing circuitry 310 and produce respective analog radio frequency signals for radio transmission by the antenna 322. In some aspects, the processing circuitry 310 may control the radio transmission and reception of the RF transceiver 320, including specifying the transmit and receive radio frequencies for the operation of the RF transceiver 320. In some examples, at least one of the amplifiers may include an amplifier circuit provided herein.

FIG. 4 shows an exemplary illustration of a transmit path of an RF transceiver. The RF transceiver 320, of which its transmit path illustrated herein, may be configured for a digital polar TX. The RF transceiver 320 may be couplable to processing circuitry (e.g. the processing circuitry 310, a modem) over an interface. The interface may include a communication path designated to carry communication signals 410 between the processing circuitry and an antenna. In some examples, the interface may include a further circuit path to provide communication between the RF transceiver 320 and the processing circuitry for control of the operations. The RF transceiver 320 may further include further components and or circuits, such as further filter circuits, synthesizer circuits, etc. that are not depicted here. The RF transceiver 320 may include various circuits and components deployed on the respective transmission path.

The RF transceiver 320 may include a digital front end (DFE) 420. The DFE 420 may receive the communication signals 410 via the interface coupling the processing circuitry to the DFE 420. The DFE 420 may include a DFE processing circuitry and further components. The DFE may 420 be configured to convert the communication signals 410 (e.g. in-phase/quadrature (IQ) signals) into a polar signal including an amplitude modulation (AM) signal (e.g. amplitude control codes) and a phase modulation (PM) signal (e.g. phase control codes).

The RF transceiver 320 may further include a digital to time converter (DTC) 430 circuit. The DTC 430 may be coupled to the DFE 420. The DTC 430 may receive the phase modulation signal. The DTC 430 may be further coupled to a local oscillator (LO) 450. The DTC 430 may adjust polar modulation parameters based on the PM signal that the DFE 420 provides to generate a modulated . By adjusting the polar modulation parameters based on the PM signal, the DTC 430 may output a modulated local oscillator (MOLO) signal.

The RF transceiver 320 may further include a digital power amplifier (DPA) 440. The DPA 440 may receive the AM signal (e.g. amplitude control codes) setting desired power of the output of the DPA 440. DPA 440 may further receive the MOLO signal and provide an output RF signal based on the received MOLO signal and received AM signal. The DPA 440 may include a DPC, or an RF-CDAC. In accordance with various aspects provided herein, the DPA 440 may include an amplifier circuit as provided in this disclosure.

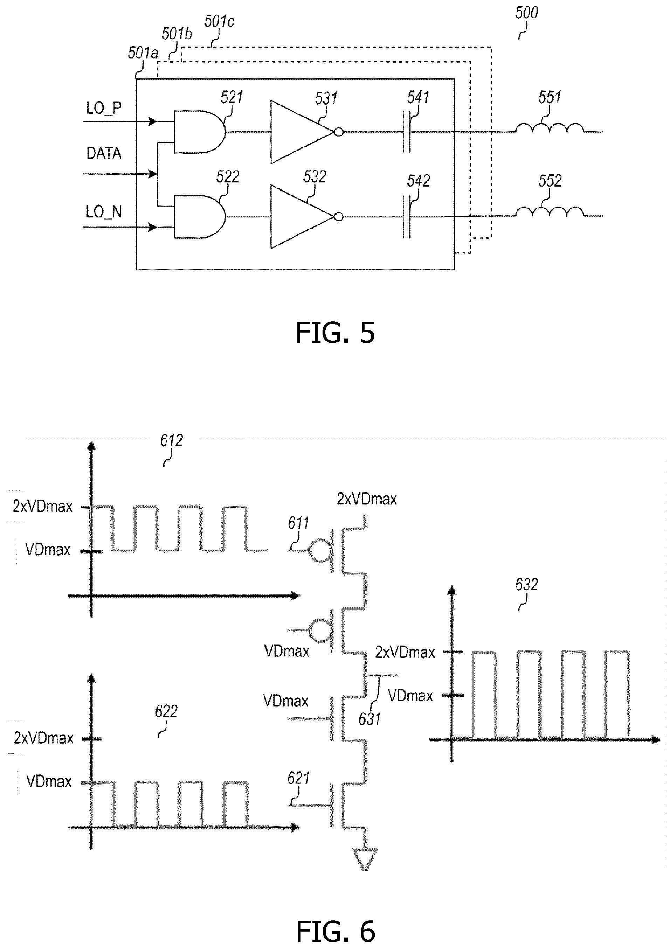

FIG. 5 schematically shows an example of an SCDPA. An amplifier of a communication device (e.g. the communication device 200, the apparatus 300, the RF transceiver 320) may include the SCDPA. The SCDPA 500 is depicted to include multiple SCDPA cells 501a-c. The illustrative example provided herein includes three SCDPA cells, 501a, 501b, and 501c. The number of SCDPA cells within the SCDPA 500 may vary depending on the desired configuration parameters associated with the SCDPA 500 and the characteristics of signals to be amplified via the SCDPA 500. Typically, the number of cells of an SCDPA may be 64, 128, 256, etc.

In this illustrative example, a SCDPA cell 501a-c is configured to receive a first input (LO_P), a second input (LO_N), and a third input (data). The first AND gate 521 may receive the LO_P signal and the data signal, and the second AND gate 522 may receive the LO_N signal and the data signal. The outputs of the two AND gates 521, 522 are connected to separate inverters 531, 532, and each inverter 531, 532 is connected to a separate capacitor 541, 542. The capacitors 541, 542 are in turn connected to separate coils 551, 552. When the LO_P signal is high, the first AND gate 521 allows the data signal to pass through to the inverter 531, which charges up the capacitor 541. When the LO_N signal is high, the second AND gate 522 allows the data signal to pass through to the other inverter 532, which charges up the other capacitor 542.The charged capacitors 541, 542 may then discharge through the coils 551, 552, creating an amplified output signal.

Inverters 531, 532 may be provided as an inverter circuit including transistors configured to act as inverters. The voltage that each transistor is capable to handle may be limited. The capability of handling may refer to a state in which the transistor can safely withstand without experiencing damage or a breakdown. For example, inverters 531, 532 may be formed with serially connected FinFETs. Exemplarily, the maximum voltage that can be applied to the drain terminal of a 16 nm FinFET (i.e. maximum voltage between the drain terminal and the source terminal), which may be referred to as VDmax (V_{Dmax}), may be around 1.1V-1.2V in a traditional SCDPA. VDmax may be even lower in, as the spatial scale of the event is lower. As the capacitors 541, 542 are charged via these transistors, the necessity to keep operational voltage (drain voltage) of the transistors below VDmax to ensure the operation of the SCDPA may introduce limitations towards output power of the SCDPA, as the capacitors are charged based on the outputs of these transistors. Accordingly, the capacitors 541, 542 may be driven by the inverters 531, 532 respectively. In accordance with various aspects provided herein, an amplifier circuit provided herein may also be referred to as SCDPA cell driver to drive the capacitors 541, 542 to output an amplified signal.

From a higher level, each SCDPA cell may receive digital data streams (e.g. in-phase digital data, quadrature-phase digital data). Each SCDPA cell may provide, via a respective capacitor, an output signal that is a digital signal based on received digital data streams. The provided output signal may be input to a DAC combining (multiple output signals from multiple SCDPA cells) and converting the digital output signal to an analog signal for radio transmission.

It is to be noted herein, that a maximum operating voltage of a transistor may also include maximum voltage levels that are applicable to any two terminals of a transistor that may damage operation of the transistor. VDmax representation provided in this disclosure as an exemplary transistor limitation in accordance with various aspects, but aspects provided herein may correspond to further voltage level limitations. In other words, it may further refer to maximum drain-source voltage, maximum drain-gate voltage, or maximum gate-source voltage of a FET, and similar voltages between terminals of other types of transistors. These limitations are generally defined by the manufacturer of the respective transistor.

In accordance with various aspects provided herein, a SCDPA may include an amplifier circuit may drive capacitors of the SCDPA, which the capacitors may provide amplified output signal via their charging/discharging operation. In some aspects, the output signal of the amplifier circuit may swing within a range that is greater than 3xVDmax. Within the limitations indicated in the above-mentioned example of 16 nm FinFETs, the amplifier circuit may provide an output signal that is greater than 3.3V-3.6V. Assuming that the supply voltage for the serially connected transistors may swing with a range that is greater than 3xVDmax, the maximum drain voltage at each transistor of the amplifier circuit may still be equal or below VDmax in this constellation in accordance with various aspects provided herein. According to various aspects provided herein, the provision of an increased voltage supply may allow the SCDPA to support higher output powers required for the support of longer distances. Furthermore, it may extend the SCDPA for using SCDPAs in more advance process nodes. It may also allow bringing the DPA low voltage domain to logic domain and optimizing power and timing issues.

It should be noted that even in current technologies, 1/3 of the supply voltage Vdd of the serially connected transistors may stress the transistors to marginal limits and can create bias temperature instability (BTI) stress when cells are off. In some examples, an amplifier circuit including a plurality of transistor stacks with more than level 3 stacking may decrease the voltage stress of the amplifier circuit. Thus, moving to a higher level of stacking can eliminate this risk and the mitigation circuits used for it. Moreover, typically logic and modulated local oscillator (MOLO) in the DTX topologies are driven from a low-dropout source (LDO) or DC2DC voltages that may be lower than the VDmax, while a DPA level shifter may work from VDmax to Vdd=3*VDmax. This results in the need for more level shifters in logic and MOLO paths that degrade timing, memory and hence increase power consumption. Various aspects provided herein may allow the removal of high power DC2DC supply resulting in cost reduction, but also improved over all efficiency in transmit mode of the communication device.

It may further be noted that although increasing the level of transistor stacking in order to distribute the supply voltage at the boundaries (i.e. the upper voltage level of the supply voltage and the lower voltage level of the supply voltage) may result in decreased drain-source voltage at the boundaries compared to a non-stacked configuration, due to the switching of the transistors over time, some of the serially connected transistors may still encounter voltage levels that are higher than VDmax in their respective drain terminals. In accordance with various aspects provided herein, the drain voltages of the transistors may be at VDmax in operation. Some aspects provided herein may result in higher load impedances due to a higher Vdd, and better trade-off of power/efficiency resulting in wider load-pull circles and less sensitivity to load.

FIG. 6 illustrates an example of an amplifier circuit with 2-level transistor stacking. An amplifier circuit illustrated herein configured to drive a capacitor of an SCDPA cell. The amplifier circuit illustrated herein includes four transistors connected in series (i.e. from their drain-source terminals respectively). The four transistors including two p-type transistors as transistors of a first conductivity type, and two n-type transistors as transistors of a second conductivity type. Exemplarily, the transistors of the first conductivity type are a first p-type transistor and a second p-type transistor connected to the first p-type transistor. The transistors of the second conductivity type are a first n-type transistor and a second n-type transistor connected to the first n-type transistor. The first p-type transistor includes a control terminal 611 (gate terminal) configured to receive a first input signal. The first n-type transistor includes a control terminal 621 configured to receive a second input signal.

Assuming that the transistors have the same VDmax, the first input signal 612 may vary within a voltage range of VDmax between an upper voltage level of 2xVDmax and a lower voltage level of VDmax. The second input signal 622 may vary within a voltage range of VDmax between an upper voltage level of VDmax and a lower voltage level of 0, the second input signal 622 being in phase with the first input signal 612. The second p-type transistor is connected to the second n-type transistor in the series connection. Control terminals of the second p-type transistor and the second n-type transistor may receive DC voltages at VDmax. The series connection of the four transistors is supplied with a DC voltage of 2xVDmax. Accordingly, output terminal 631 of the amplifier circuit, which the output terminal 631 is coupled to the second p-type transistor and the second n-type transistor. Output signal 632 of the amplifier circuit may vary within a voltage range of 0 and 2xVDmax. In this configuration, the voltage swings between drain-source terminals of each transistor may be in a range of 0-VDmax.

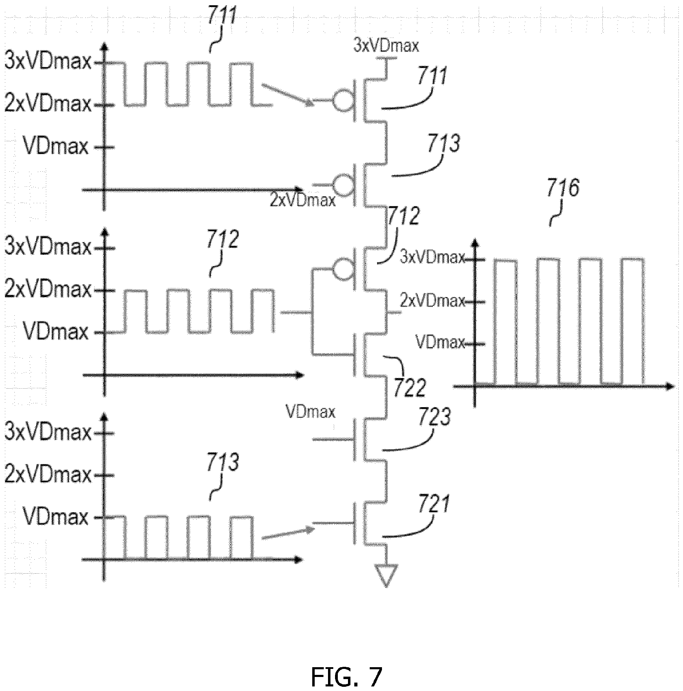

FIG. 7 illustrates an example of an amplifier circuit with 3-level transistor stacking. An amplifier circuit illustrated herein may be configured to drive a capacitor of an SCDPA cell. The amplifier circuit illustrated herein includes six transistors 711, 712, 713, 721, 722, 723 connected in series (i.e. from their drain-source terminals respectively). The six transistors may include three p-type transistors 711, 712, 713 as transistors of a first conductivity type, and three n-type transistors 721, 722, 723 as transistors of a second conductivity type. Exemplarily, the transistors of the first conductivity type are a first p-type transistor 711, a second p-type transistor 712, and a third p-type transistor 713 connected to each other. The transistors of the second conductivity type are a first n-type transistor 721, a second n-type transistor 722, and a third n-type transistor 723. The first p-type transistor 711 may receive a first input signal and the first n-type transistor 721 may receive a second input signal from their respective control (e.g. gate) terminals.

Assuming that the transistors have the same VDmax, the first input signal 731 may vary within a voltage range of VDmax between an upper voltage level of 3xVDmax and a lower voltage level of 2xVDmax. The second input signal 732 may vary within a voltage range of VDmax between an upper voltage level of VDmax and a lower voltage level of 0, the second input signal 622 being in phase with the first input signal 612.

The second p-type transistor 712 is connected to the second n-type transistor 722 in the series connection from their drain terminals. The third p-type transistor 713 may be connected between the first p-type transistor 711 and the second p-type transistor (i.e. to the drain terminal of the first p-type transistor 711 and the source terminal of the second p-type transistor 712) in the series connection. The third n-type transistor 723 may be connected between the first n-type transistor 721 and the second n-type transistor 722 (i.e. to the drain terminal of the first n-type transistor 721 and the source terminal of the second n-type transistor 722) in the series connection. A first DC voltage of 2xVDmax may be provided to the control terminal of the third p-type transistor 713. A second DC voltage of VDmax may be provided to the control terminal of the third n-type transistor 723.

Accordingly, an output terminal of the amplifier circuit, which the output terminal is coupled to the drain terminals of the second p-type transistor 712 and the second n-type transistor 722 may output an output signal 730. A supply voltage (e.g. by a voltage supplier) may be provided to the series connection of the transistors 711, 712, 713, 721, 722, 723. The supply voltage may be 3xVDmax.The output signal 730 of the amplifier circuit may vary within a voltage range of 0 and 3xVDmax.

In such a configuration with 3-level stacking, proper signaling is to be provided to inner transistors of the amplifier circuit, such as the second p-type transistor 712 and the second n-type transistor 722 to drive them in order to provide a desired contribution to the output signal 730. In this illustrative example, a common terminal that is connected to control terminals of the second p-type transistor 712 and the second n-type transistor is supplied by a third input signal 733. In this configuration, the voltage may swing between drain-source terminals of each transistor may be in a range of 0-VDmax. In other words, the maximum voltage for each transistor 711, 712, 713, 721, 722, 723 in the series connection should be below VDmax to avoid excessive voltage that may damage the operation of the transistors.

Application of fixed DC voltages to gates of the second p-type transistor 712 and the second n-type transistor 722 might have caused transistors to face voltage levels that are above VDmax over time. For this reason, the third input signal 733 may vary in-phase with the output signal 730 and proportional (e.g. 1/3) of the output signal 730. The proportion provided here may include 1/L, L being the level of transistor stacking of the amplifier circuit for the transistors in the series connection. The third input signal 733 may vary between the upper voltage level of the second input signal 732 and the lower voltage level of the first input signal 731.

In accordance with various aspects provided herein, a feedback circuit configured to provide the third input signal as a feedback signal based on the output signal 730. The feedback signal provided by the feedback circuit may be in-phase with the output signal 730 and proportional to the output signal 730. In some aspects, the feedback circuit may be a capacitive divider feedback circuit.

Capacitive divider feedback is a technique to generate an in-phase signal to control the operation of the inner transistors. Using the capacitive divider feedback, it is aimed to keep the inner transistors (e.g. the second p-type transistor 712 and the second n-type transistor 722) in the reliability safe zone, which is the operating range where the transistors are less likely to fail or be damaged. A capacitive divider feedback may include a capacitive divider network to generate an in-phase feedback signal that is proportional to the output signal 730. This feedback signal is provided to control the gate drive of the inner transistors.

The capacitive divider network may include two or more capacitors connected in series. The feedback signal is taken from the tap between the capacitors and fed back to the gate of the inner transistors. By controlling the inner transistors via the feedback signal that is based on the output signal, the amplifier circuit may operate in a more stable and reliable manner. In some aspects provided herein, one or more feedback transistors may provide the capacitive divider feedback.

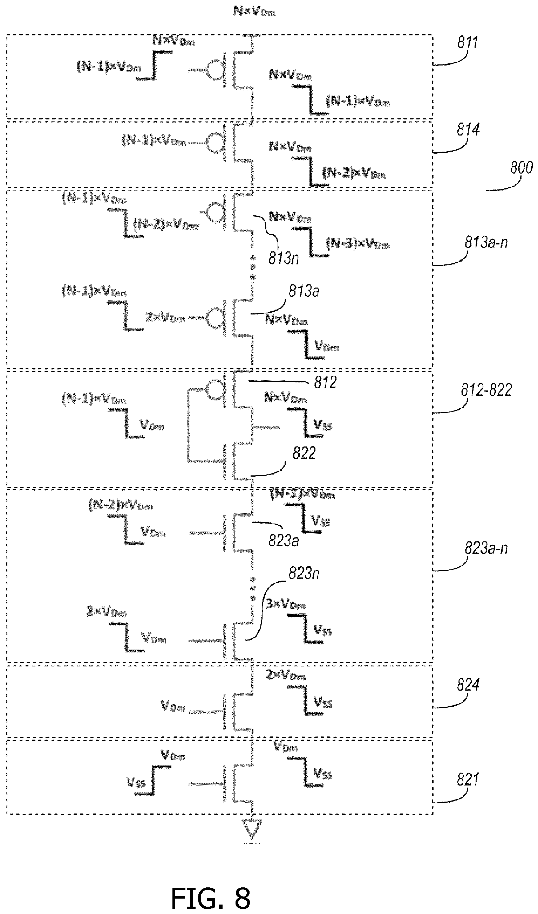

FIG. 8 shows an exemplary illustration of an amplifier circuit configured to drive a capacitor of an SCDPA cell in accordance with various aspects provided herein. The amplifier circuit 800 is of N-level stacking including N transistors of a first conductivity type (e.g. p-type) and N transistors of a second conductivity type (e.g. n-type) connected in a series connection connected to a supply voltage. The number N may be 3, 4, 5, 6, 7, or a further integer greater than 7 depending on the desired stacking level. In some aspects, the number N may be 4 at minimum in accordance with various aspects provided in this disclosure. Analogous to FIGs 6 and 7, it is depicted herein that the amplifier circuit 800 may include a first p-type transistor 811 at a first end of the series connection, the first p-type transistor 811 is configured to receive a first input signal from its gate. The source of the first p-type transistor 811 is connected to a voltage supplier configured to provide voltage of NxVDm. The amplifier circuit 800 may further include a first n-type transistor 821 at a second end of the series connection, the first n-type transistor 821 is configured to receive a second input signal from its gate. The source of the first n-type transistor is connected to the ground. The skilled person would recognize that any possible configuration may be derivable to form a voltage level of NxVDm between the first end of the series connection and the second end of the series connection.

The notation provided herein associated with VDm may be considered to represent a voltage level associated with the supply voltage, namely VDm. In consideration of aspects associated with providing optimum voltage output, the supply voltage NxVDm may be NxVDmax, VDmax being the maximum operation voltage (e.g. drain-source voltage) of each transistor of the transistors in the series connection. In some aspects, the corresponding signal levels provided to gates of each of the transistors in the series connection may also be considered in a manner that VDm=VDmax.

The first p-type transistor 811 and the first n-type transistor 821 may be coupled to a second p-type transistor 812 and a second n-type transistor 822 respectively, through respective further transistors in-between, which the further transistors are explained below. The amplifier circuit 800 may provide an output signal from an output terminal that is connected to the drain terminal of the second p-type transistor 812 and the drain terminal of the second n-type transistor 822. The output terminal may be connected to a capacitor of the SCDPA cell. In this constellation, the output signal of the amplifier circuit 800 may vary with a peak-to-peak voltage of NxVDmax, e.g. between 0V and NxVDmax. Correspondingly, as the number of levels in the stacking increases, the supply voltage may also be increased.

The amplifier circuit 800 may further include one or more third p-type transistors 813a-n in the series connection coupled to the first p-type transistor 811 and the second p-type transistor 812 (e.g. coupled between the first p-type transistor 811 and the second p-type transistor 812). At a first end, the drain of a first one of the one or more third p-type transistors 813a may be coupled to the source of the second p-type transistor 812. At a second end, the source of a second one of the one or more third p-type transistors 813n may be coupled to the drain of the first p-type transistor 811. In case N=4, the first one and the second one of the one or more third p-type transistors 813a-n may be the same p-type transistor. Similarly, on other conductivity portion, the amplifier circuit 800 may further include one or more third n-type transistors 823a-n in the series connection coupled to the first n-type transistor 821 and the second n-type transistor 822 (e.g. coupled between the first n-type transistor 821 and the second n-type transistor 822). At a first end, the drain of a first one of the one or more third n-type transistors 823a may be coupled to the source of the second n-type transistor 822. At a second end, the source of a second one of the one or more third n-type transistors 823n may be coupled to the drain of the first n-type transistor 821. The numbers of the third p-type transistors 813a-n and the third n-type transistors 823a-n may be N-3. In case N=4, the first one and the second one of the one or more third n-type transistors 823a-n may be the same n-type transistor.

Furthermore, the amplifier circuit 800 may include a fourth p-type transistor 814 coupled to the drain of the first p-type transistor 811 with its source and to the one or more third p-type transistors 813a-n with its drain within the series connection. The amplifier circuit 800 may further include a fourth n-type transistor 824 coupled to the drain of the first n-type transistor 821 with its source and to the one or more third n-type transistors 823a-n with its drain within the series connection.

In accordance with various aspects provided herein, the voltage configuration of each transistor in the series connection should be arranged to provide sufficient drive current and obtain desired output power, while also maintaining the stability of the amplifier circuit 800 (e.g. considering VDmax limitation) and preventing distortion. The details of the voltage configurations are to be explained in more detail in the following section. It is to be considered that the amplifier circuit 800 may include any suitable means to provide corresponding control signals (i.e. gate signals) to the transistor in the series connection in order to cause the amplifier circuit 800 to provide the output signal, while also causing each transistor to operate with a drain-source voltage as provided herein. A supply controller or one or more supply controllers, each one of the one or more supply controllers being specific to one of the transistors in the series connection, may provide the corresponding control signals. In some examples, a feedback circuit or one or more feedback circuits, each one of the one or more feedback circuits being specific to one of the transistors in the series connection, may provide the corresponding control signals. As can be seen, FIG. 8 further illustrates voltage swings applicable to each control terminal (e.g. gate terminal) of the transistors of the amplifier circuit 800, which may be referred to as an input signal corresponding to the respective transistor in the series connection, and voltage swings that may be observed at each drain terminal of the transistors of the amplifier circuit 800, which may be referred to as an output signal corresponding to the respective transistor in the series connection (i.e. drain voltage, the voltage between the drain terminal of the corresponding transistor and the Vss (e.g. ground, 0V)). The illustrated voltage signals may represent corresponding input signals/control signals to be provided by suitable means as explained herein.

A first input signal provided to the first p-type transistor 811 may have a peak-to-peak voltage of VDm (i.e. a first range of VDm) varying between an upper voltage level of NxVDm and a lower voltage level of (N-1)xVDm according to a first phase. The drain voltage of the first p-type transistor 811 may have a peak-to-peak voltage of VDm varying between an upper voltage level NxVDm and a lower voltage level (N-1)xVDm according to a second phase that is opposite of the first phase. A signal with a phase that is opposite of a phase of another signal may represent that when the input signal level is at the upper voltage level, the output signal level is at the lower voltage level, and when the input signal level is at the lower voltage level, the output signal level is at the upper voltage level.

A second input signal provided to the first n-type transistor 821 may have a peak-to-peak voltage of VDm (i.e. a first range of VDm) varying between an upper voltage level of VDm and a lower voltage level of Vss (e.g. negative power supply, 0V, ground) according to a first phase. The drain voltage of the first n-type transistor 821 may have a peak-to-peak voltage of VDm varying between an upper voltage level of VDm and a lower voltage level of Vss according to a second phase that is opposite of the first phase. It is to be considered that, in an SCDPA cell, the first input signal and the second input signal may be provided with an oscillator that is used to control the SCDPA cell. In some aspects provided herein, a level shifter circuit may provide the first input signal and the second input signal.

In accordance with various aspects provided herein, a DC voltage supplier may provide a first DC voltage at (N-1)xVDm to the gate of the fourth p-type transistor 814. The amplifier circuit 800 may include one or more components that are configured to cause the output voltage (e.g. drain) of the fourth p-type transistor 814 to have a peak-to-peak voltage of 2xVDm varying between an upper voltage level of NxVDm and a lower voltage level of (N-2)xVDm according to the second phase. Similarly, a DC voltage supplier may provide a second DC voltage at VDm to the gate of the fourth n-type transistor 824. The amplifier circuit 800 may include one or more components that are configured to cause the output voltage (e.g. drain) of the fourth n-type transistor 824 to have a peak-to-peak voltage of 2xVDm varying between an upper voltage level of 2xVDm and a lower voltage level of Vss according to the second phase.

In accordance with various aspects provided herein, gate terminals of the second p-type transistor 812 and the second n-type transistor 822 are coupled to a common terminal. The common terminal may receive a signal with a voltage level range of (N-2)xVDm varying between an upper voltage level of (N-1)xVDm and a lower voltage level of VDm that is according to the second phase which is opposite of the phase of the first input signal and the second input signal. Considering the presence of the output signal from the output terminal of the amplifier circuit 800, the output signal is desired to have a voltage level within an output voltage range between the first upper voltage level of the first input signal and the second lower voltage level of the second input signal, namely NxVDm-Vss (e.g. NxVDm, Vss being 0V), which the phase of the output signal of the amplifier circuit 800 being the second phase. The signal input to the common terminal (i.e. signal input to the gates of the second p-type transistor 812 and the second n-type transistor may be according to the second phase.

In accordance with various aspects provided herein, the amplifier circuit 800 may include one or more components (e.g. a feedback circuit) that are configured to provide the signal input to the gates of the second p-type transistor 812 and the second n-type transistor 822, which the provided signal is in phase with the output signal of the amplifier circuit 800 (i.e. voltage at the drain terminal of the second p-type transistor 812 or the drain terminal of the first p-type transistor). In some aspects, the voltage range of the provided signal is proportional to the output signal, which the proportion may be (N-2)/N. As an illustrative example, for N=4, the output signal may have a range of 4xVDm, while the corresponding provided signal may have a range of 2xVDm. Upper voltage level of the provided signal may be the first lower voltage level of the first input signal. Lower voltage level of the provided signal may be the second upper voltage level of the second input signal.

In some aspects, a further signal supplier (e.g. a level shifter) may provide the corresponding signal to the gates of the second p-type transistor 812 and the second n-type transistor 822 in the above-mentioned configuration. In some aspects, the amplifier circuit 800 may include a feedback circuit that is configured to provide a feedback signal that is in phase with, and proportional to, output signal of the amplifier circuit 800 (i.e. drain terminals of the second p-type transistor 812 and the second n-type transistor 822). The feedback circuit may be a capacitive divider feedback circuit configured to generate an in-phase feedback signal that is proportional to the output signal of the amplifier circuit 800.

Control signals for one or more third p-type transistors 813a-n and the one or more third n-type transistors (the number of transistors of each type being N-3) are explained here with examples of a first one 813a and a second one 813n of the one or more third p-type transistors 813a-n and a first one 823a and a second one 823n of the one or more third n-type transistors 823a-n. As can be seen from the FIG. 8 itself, these control signals are in-phase with the output signal of the amplifier circuit 800 and proportional to the output signal of the amplifier circuit 800 with different proportions. The skilled person would recognize how aspects provided herein may be populated for intermediary transistors of the one or more third p-type transistors 813a-n and the one or more third n-type transistors 823a-n.

The gate of the first one 813a of the third p-type transistors may receive a gate signal (sometimes referred to as a first gate signal) with a range of (N-3)xVDm varying between an upper voltage level of (N-1)xVDm (i.e. the first lower voltage level of the first input signal) and a lower voltage level of 2xVDm. The drain voltage of the first one 813a of the third p-type transistors may have a range of (N-1)xVDm varying between an upper voltage level of NxVDm and a lower voltage level of VDm. The gate of the first one 823a of the third n-type transistors may receive a gate signal (sometimes referred to as a second gate signal) with a range of (N-3)xVDm varying between an upper voltage level of (N-2)xVDm and a lower voltage level of VDm (i.e. the second upper voltage level of the second input signal). The drain voltage of the first one 823a of the third n-type transistors may have a range of (N-1)xVDm varying between an upper voltage level of (N-1)xVDm and a lower voltage level of Vss.

The gate of the second one 813n of the third p-type transistors may receive a gate signal (sometimes referred to as a first gate signal) with a range of VDm varying between an upper voltage level of (N-1)xVDm (i.e. the first lower voltage level of the first input signal) and a lower voltage level of (N-2)xVDm. The drain voltage of the second one 813n of the third p-type transistors may have a range of 3xVDm varying between an upper voltage level of NxVDm and a lower voltage level of (N-3)xVDm. The gate of the second one 823n of the third n-type transistors may receive a gate signal with a range of 3xVDm varying between an upper voltage level of 3xVDm and a lower voltage level of Vss (i.e. the second lower voltage level of the second input signal).

In accordance with various aspects provided herein, the amplifier circuit 800 may include one or more components (e.g. a feedback circuit) that are configured to provide the above-mentioned gate signals to the gates of the one or more third p-type transistors 813a-n and the one or more third n-type transistors 823a-n, which the provided gate signals are in phase with the output signal of the amplifier circuit 800 (i.e. voltage at the drain terminal of the second p-type transistor 812 or the drain terminal of the first p-type transistor). In some aspects, the voltage range of each of the provided gate signals is proportional to the output signal with different proportions, as indicated above.

In some aspects, a further signal supplier (e.g. a level shifter) may provide the corresponding gate signals to the gates of the one or more third p-type transistors 813a-n and the one or more third n-type transistors 823a-n respectively. In some aspects, the amplifier circuit 800 may include one or more feedback circuits that are configured to provide respective feedback signals as the corresponding gate signals. The feedback signals may be in phase with, and proportional to, output signal of the amplifier circuit 800 (i.e. drain terminals of the second p-type transistor 812 and the second n-type transistor 822). The feedback circuit may be a capacitive divider feedback circuit configured to generate an in-phase feedback signal that is proportional to the output signal of the amplifier circuit 800.

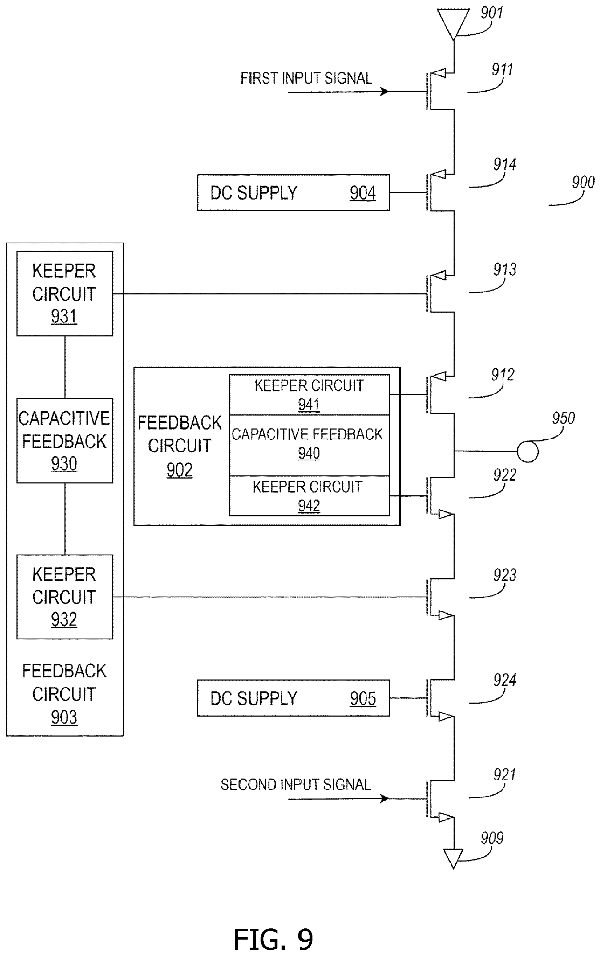

FIG. 9 illustrates an example of an amplifier circuit with 4-level stacking. The amplifier circuit 900 may be configured to operate in accordance with input/gate signals and output signals provided herein (e.g. in accordance with aspects of the amplifier circuit 800). The amplifier circuit 900 includes a plurality of transistors connected in series for providing a circuit output signal to drive a capacitor of an SCDPA from an output terminal 950. The amplifier circuit 900 may receive a first input signal with a range of VDm, the first input signal (e.g. first digital signal) varying between a first upper voltage level of 4xVDm and a first lower voltage level of 3xVDm. The amplifier circuit 900 may receive a second input signal with a range of VDm, the second input signal (e.g. second digital signal) varying between a second upper voltage level of VDm and a second lower voltage level of 0V. A level shifter may provide the first input signal and the second input signal. A voltage supplier may provide a supply voltage 901 of 4xVDm to a first end of the series connection. Second end of the series connection may be connected to the ground 909.

The notation provided herein associated with VDm may be considered to represent a voltage level associated with the supply voltage. In consideration of aspects associated with providing optimum voltage output, the supply voltage NxVDm may be NxVDmax, VDmax being the maximum operation voltage (e.g. drain-source voltage) of each transistor of the plurality of transistors in the series connection. In some aspects, the corresponding signal levels provided to gates of each of the transistors in the series connection may also be considered in a manner that VDm=VDmax. In some aspects, VDm may be smaller than VDmax.

The plurality of transistors of the amplifier circuit 900 may include transistors of a first conductivity type, which are provided herein as p-type transistors for exemplary purposes, including a first p-type transistor 911, a second p-type transistor 912, a third p-type transistor 913, and a fourth p-type transistor 914. The plurality of transistors of the amplifier circuit 900 may include transistors of a second conductivity type, which are provided herein as n-type transistors for exemplary purposes, including a first n-type transistor 921, a second n-type transistor 922, a third n-type transistor 923, and a fourth n-type transistor 924.

Analogous to aspects provided in accordance with FIG.8 and following a similar notation and configuration, the first p-type transistor 911 and the first n-type transistor 921 may receive the first input signal and the second input signal respectively. The first p-type transistor 911 may be configured to receive the supply voltage 901 with its source terminal. The first n-type transistor 921 may be connected to the ground 909 with its source terminal. The output terminal 950 of the amplifier circuit 900 may be coupled to the drain of the second p-type transistor 912 and the second n-type transistor 922. The fourth p-type transistor 914 is coupled, via its source, to the drain of the first p-type transistor 911. The third p-type transistor 913 is coupled, via its source, to the drain of the fourth p-type transistor 914. The second p-type transistor 912 is coupled, via its source, to the drain of the third p-type transistor 913. The fourth n-type transistor 924 is coupled, via its source, to the drain of the first n-type transistor 921. The third n-type transistor 923 is coupled, via its source, to the drain of the fourth n-type transistor 924. The second n-type transistor 922 is coupled, via its source, to the drain of the third n-type transistor 913. The gate of the fourth p-type transistor 914 may be connected to a first DC supply 904 configured to provide a DC voltage of 3xVDm. The gate of the fourth n-type transistor 924 may be connected to a second DC supply 904 configured to provide a DC voltage of VDm.

In accordance with various aspects provided herein, the amplifier circuit 900 may include components configured to drive inner transistors including the second p-type transistor 912, the second n-type transistor 922, the third p-type transistor 913, the third n-type transistor 923, namely transistors other than the transistors driven with external input signals (e.g. the first input signal and the second input signal) or the transistors driven with a DC supply. The components may be configured to drive the inner transistors, such that the corresponding operation voltage of each of the inner transistors would be equal to VDmax or less than VDmax, VDmax being the maximum operation voltage (e.g. drain-source voltage) of the respective inner transistor.

Referring back to voltage swings illustrated in FIG. 8, inconsideration of the voltage swings at the drain terminal of the first p-type transistor 911 and the first n-type transistor, and the voltage swings of the inner transistors 912, 913, 922, 923, which the aspects of the voltage swings are further provided in the following sections, the fourth p-type transistor 914 and the fourth n-type transistor 924 may be supplied by DC voltage, and the drain-source voltage of each of the fourth p-type transistor 914 and the fourth n-type transistor 924 may be equal to VDmax or below.

Although the gate/control signals to control the operation of the inner transistors 912, 913, 922, 923 may be provided by an external signal supplier, the necessity of maintaining the operation voltages of the inner transistors 912, 913, 922, 923 as indicated in FIG. 8 may not be provided, as this brings further complexity to the communication circuit to provide the necessary synchronization and voltages. The referred necessity may be for the purpose of dividing the supply voltage 901 between the transistors in the series, such that voltage swing at the drain-source voltage of each transistor would be maximum at VDmax, Accordingly, the amplifier circuit 900 may include inner drivers that are configured to drive the inner transistors 912, 913, 922, 923, such that the voltage swing at the drain-source of each inner transistor 912, 913, 922, 923 would be maximum at VDmax over time. The inner drivers may drive the inner transistors 912, 913, 922, 923 based on one or more voltage levels of the amplifier circuit 900, in particular the voltage levels of the output signal.

Inner drivers may include one or more feedback circuits. A feedback circuit in accordance with various aspects provided herein may be coupled to the series connection of the plurality of transistors in order to track a voltage level at the series connection. In particular, the feedback circuit may track the output signal of the amplifier circuit 900. In other words, the feedback circuit may generate a signal (i.e. feedback signal) that is tracking the output signal, which one of the inner transistors 912, 913, 922, 923 may receive the generated signal. The generated signal may be based on the output signal. The generated signal may be in-phase with the output signal. In some examples, the generated signal may track a drain voltage of the corresponding transistor. In other words, the generated signal for one of the inner transistors 912, 913, 922, 923 may be in-phase with the drain voltage of the one of the inner transistors 912, 913, 922, 923.

The feedback circuit may be configured to provide a capacitive divider feedback via a capacitive divider. A capacitive divider may not pass the DC portion of the divided signal. Furthermore, a capacitive divider is generally not affected by changes in the frequency, and accordingly, the amplifier circuit 900 may be suitable for operating with signals with various frequencies or frequency bands. A capacitive divider may traditionally include two or more capacitors connected in series, and a terminal between the series connection of the capacitors may provide the generated signal that is tracking the divided signal. The feedback circuit may include a feedback transistor with a suitable conductivity type to control the generated signal. In some examples, the feedback transistor may form the capacitive divider via its capacitance between its terminals (e.g. gate-drain capacitance). Exemplarily, the feedback transistor having a first or second conductivity type (e.g. p-type or n-type MOS) may be connected via its gate terminal, to a gate terminal of a respective transistor at the series connection.

For some aspects, the feedback circuit may further include a keeper circuit for at least one of the inner transistors 912, 913, 922, 923. The keeper circuit may be configured to maintain the voltage level between the drain-source terminals of the at least one of the inner transistors 912, 913, 922, 923 to be maximum at VDm (e.g. VDmax). For example, the keeper circuit for a respective inner transistor may cause the voltage level between the drain terminal of the respective inner transistor and the source terminal to stay between a range of VDm (e.g. VDmax) having an upper voltage level and a lower voltage level. In other words, the keeper circuit may cause the respective inner transistor to operate with a voltage swing of VDm, the voltage being the voltage between the source and drain of the respective inner transistor. The keeper circuit may cause the voltage level between the drain and the source to be maximum a predetermined upper voltage level and minimum a predetermined lower voltage level, the difference between the predetermined upper voltage level and the predetermined lower voltage level being VDm.

In some aspects, the amplifier circuit 900 may include multiple keeper circuits, exemplarily a keeper circuit for each inner transistor 912, 913, 922, 923. For the respective inner transistor, in order to maintain the voltage levels within the range of VDm (e.g. VDmax) while the voltage of the drain terminal (voltage between the drain and the ground 909) of the respective inner transistor swings with a range greater than VDm, the keeper circuit may be configured to operate based on a signal that is in-phase with the output signal of the amplifier circuit 900. The signal may be also proportional to the output signal of the amplifier circuit 900. In some examples, the keeper circuit may be configured to control the voltage swing of the respective inner transistor based on the divided signal that the capacitive divider generates.

In this illustrative example, the amplifier circuit 900 includes a first feedback circuit 902 configured to generate gate signals that are in-phase with and proportional to the output signal of the amplifier circuit 900 for first inner transistors, namely for the second p-type transistor 912 and the second n-type transistor 922. Furthermore, the amplifier circuit 900 includes a second feedback circuit 903 configured to generate gate signals that are in-phase with and proportional to the output signal of the amplifier circuit 900 for second inner transistors, namely for the third p-type transistor 913 and the third n-type transistor 923. Considering the aspects provided herein, the amplifier circuit 900 may further include further feedback circuits for further inner transistor pairs in the series connection for an amplifier stack with more than 4-level stacking (e.g. 5-level, 6-level, etc.), for which the aspects provided herein with respect to the first feedback circuit 902 and the second feedback circuit 903 may apply.

The first feedback circuit 902 may provide a first feedback signal to the gate of the second p-type transistor 912 and a second feedback signal to the gate of the second n-type transistor 922. The first generated signal and the second generated signal may be in-phase with the output signal of the amplifier circuit 900, and proportional to the output signal of the amplifier circuit 900.

The first feedback circuit 902 may include a capacitive divider 940. The capacitive divider 940 may be configured to generate a signal based on the output signal of the amplifier circuit 900. The capacitive divider 940 may include a first p-type feedback transistor. The gate of the first p-type feedback transistor may be coupled to the gate of the second p-type transistor 912. The capacitive divider 940 may include a first n-type feedback transistor. The gate of the first n-type feedback transistor may be coupled to the gate of the second n-type transistor 922.

The first feedback circuit 902 may further include a first keeper circuit 941 and a second keeper circuit 941. The first keeper circuit 941 may be coupled to the gate of the second p-type transistor 912. The first keeper circuit 941 may be configured to maintain the voltage swing of the drain-source of the second p-type transistor 912 within a range of VDm (e.g. VDmax). The first keeper circuit 941 may provide a gate signal, such that the drain voltage (e.g. drain-ground 909) of the second p-type transistor 912 may have a voltage swing of 4xVDm (e.g. 4xVDmax). Similarly, the second keeper circuit 942 may be coupled to the gate of the second n-type transistor 922. The second keeper circuit 942 may be configured to maintain the voltage swing of the drain-source of the second n-type transistor 912 within a range of VDm (e.g. VDmax). The second keeper circuit 942 may provide a gate signal, such that the drain voltage (e.g. drain-ground 909) of the second n-type transistor 922 may have a voltage swing of 4xVDm (e.g. VDmax).

Each keeper circuit 941, 942 may include pull-up/pull-down keepers. The pull-up/pull-down keepers may maintain the voltage level range of the voltage swing to be at VDmax by implementing an upper voltage level and a lower voltage level for the respective second transistors 912, 922 respectively. The pull-up keeper may include a pull-up transistor that is configured to maintain the upper voltage level. When the respective voltage level is higher, the pull-up transistor is turned on which keeps the upper voltage level. Similarly, the pull-down keeper may include a pull-down transistor that is configured to maintain the lower voltage level. When the respective voltage is lower, the pull-down transistor is turned on, which keeps the lower voltage level.

Accordingly, the gates of the second p-type transistor 912 and the second n-type transistor 922 may receive a gate signal with a voltage level range of 2xVDm. The received gate signal varies between 3xVDm and VDm. The received gate signal is in-phase with the drain voltage (drain-ground 909) of the second p-type transistor 912 and the second n-type transistor 922. The received gate signal has a voltage level that is proportional to the drain voltage (drain-ground 909) of the second p-type transistor 912 and the second n-type transistor 922. The received gate signal has a peak-to-peak voltage that is half of the drain voltage (drain-ground 909) of the second p-type transistor 912 and the second n-type transistor 922 for 4-level stacking. For higher level stacking, the received gate signal has a peak-to-peak voltage of (N-2)/N of the drain voltage (drain-ground 909) of the second p-type transistor 912 and the second n-type transistor 922, N being the level of stacking.

The second feedback circuit 903 may provide a first feedback signal to the gate of the third p-type transistor 913 and a second feedback signal to the gate of the third n-type transistor 923. The first generated signal and the second generated signal may be in-phase with the output signal of the amplifier circuit 900, and proportional to the output signal of the amplifier circuit 900.

The second feedback circuit 903 may include a further capacitive divider 930. The capacitive divider 930 may be configured to generate a signal based on the output signal of the amplifier circuit 900. The capacitive divider 930 may include a first p-type feedback transistor. The gate of the first p-type feedback transistor may be coupled to the gate of the third p-type transistor 913. The capacitive divider 930 may include a first n-type feedback transistor. The gate of the first n-type feedback transistor may be coupled to the gate of the third n-type transistor 923.

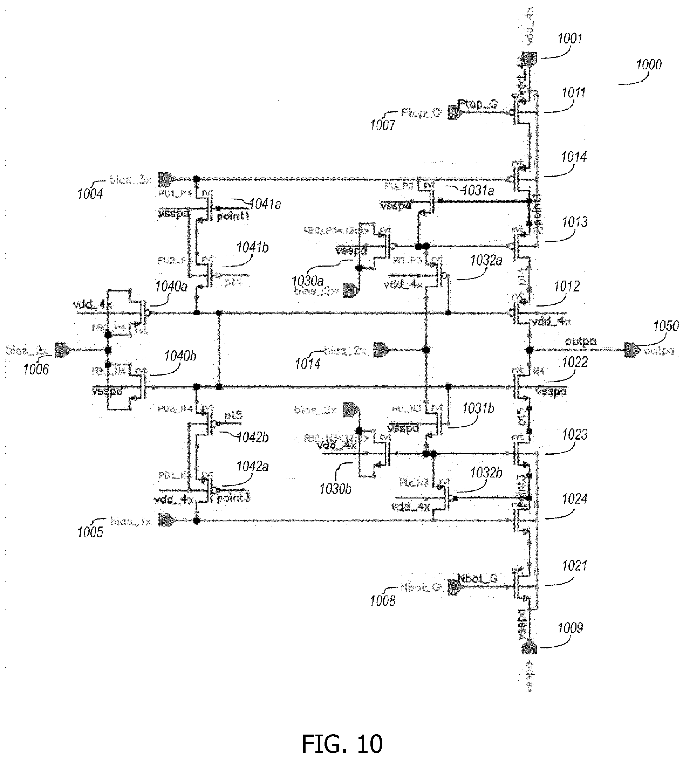

In some examples, the second feedback circuit 903 may be implemented by a first circuit including a first feedback transistor for a first capacitive feedback for the third p-type transistor 913 and a second circuit including a second feedback transistor for a second capacitive feedback for the third n-type transistor 923, as exemplified in FIG. 10.

The second feedback circuit 903 may further include a first keeper circuit 931 and a second keeper circuit 931. The first keeper circuit 931 may be coupled to the gate of the third p-type transistor 913. The first keeper circuit 931 may be configured to maintain the voltage swing of the drain-source of the third p-type transistor 913 within a range of VDm (e.g. VDmax). The first keeper circuit 931 may provide a gate signal, such that the drain voltage (e.g. drain-ground 909) of the third p-type transistor 913 may have the voltage swing of 3xVDm (e.g. 3xVDmax). The upper voltage level of the voltage swing may be the first upper voltage level of the first signal, namely 4xVDm (e.g. 4xVDmax). The lower voltage level of the voltage swing may be the second upper voltage level of the second signal, namely VDm (e.g. VDmax).

Similarly, the second keeper circuit 932 may be coupled to the gate of the third n-type transistor 923. The second keeper circuit 932 may be configured to maintain the voltage swing of the drain-source of the third n-type transistor 913 within a range of VDm (e.g. VDmax). The second keeper circuit 932 may provide a gate signal, such that the drain voltage (e.g. drain-ground 909) of the second n-type transistor 922 may have a voltage swing of 3xVDm (e.g. VDmax). The upper voltage level of the voltage swing may be the first lower voltage level of the first signal, namely 3xVDm (e.g. 3xVDmax). The lower voltage level of the voltage swing may be the second lower voltage level of the second signal, namely Vss (e.g. 0 V). For further examples associated with N-level stacking, corresponding voltage levels are provided in FIG. 8.

In some examples, in which the second feedback circuit 903 is implemented by a first circuit including a first feedback transistor for a first capacitive feedback for the third p-type transistor 913 and a second circuit including a second feedback transistor for a second capacitive feedback for the third n-type transistor 923, as exemplified in FIG. 10, the first keeper circuit 931 may be coupled to the first circuit and the second keeper circuit 932 may be coupled to the second circuit.

Each keeper circuit 931, 932 may include pull-up/pull-down keepers. The pull-up/pull-down keepers may maintain the voltage level range of the voltage swing to be at VDmax by implementing an upper voltage level and a lower voltage level for the respective third transistors 913, 923 respectively. The pull-up keeper may include a pull-up transistor that is configured to maintain the corresponding upper voltage level. When the respective voltage level is higher, the pull-up transistor is turned on, which keeps the upper voltage level. Similarly, the pull-down keeper may include a pull-down transistor that is configured to maintain the corresponding lower voltage level. When the respective voltage is lower, the pull-down transistor is turned on, which keeps the lower voltage level.

Accordingly, the gate of the third p-type transistor 913 may receive a first gate signal with a voltage level range of VDm (e.g. VDmax). The received gate signal may vary between 3xVDm and 2xVDm. The received gate signal is in-phase with the output signal of the amplifier circuit 900 (i.e. with the drain voltage (drain-ground 909) of the second p-type transistor 912 and the second n-type transistor 922). The received gate signal has a voltage level that is proportional to the output signal of the amplifier circuit 900. The received gate signal has a peak-to-peak voltage that is a quarter of the output signal for the amplifier circuit for 4-level stacking. For a higher level stacking, the received gate signal has a peak-to-peak voltage of (N-3)/N of the output voltage of the amplifier circuit 900, N being the level of stacking.

Similarly, the gate of the third n-type transistor 923 may receive a second gate signal with a voltage level range of VDm (e.g. VDmax). The received gate signal may vary between 2xVDm and VDm. The received gate signal is in-phase with the output signal of the amplifier circuit 900 (i.e. with the drain voltage (drain-ground 909) of the second p-type transistor 912 and the second n-type transistor 922). The received gate signal has a voltage level that is proportional to the output signal of the amplifier circuit 900. The received gate signal has a peak-to-peak voltage that is a quarter of the output signal for the amplifier circuit for 4-level stacking. For a higher level stacking, the received gate signal has a peak-to-peak voltage of (N-3)/N of the output voltage of the amplifier circuit 900, N being the level of stacking.

Accordingly, via the first feedback circuit 902 and the second feedback circuit 903, voltage levels of the inner transistors 912, 913, 922, 923 are provided in accordance with the illustration of FIG. 8. Through the proper timing and configuration of corresponding signals at the control terminals (e.g. gate) that are in-phase with the output signal of the amplifier circuit 900, which may be the drain voltages of the second p-type transistor 912 and the second n-type transistor 913, the voltage swings at the drain-source terminals of the inner transistors 912, 913, 922, 923 may be provided within a maximum operation voltage of the respective transistors (i.e. VDmax).

FIG. 10 illustrates an example of an amplifier circuit with 4-level stacking. The amplifier circuit 1000 may implement the aspects explained in accordance with FIGs. 8 and 9. Therefore, aspects provided herein for FIGs. 8 and 9 may apply the teachings provided for FIG. 10. The amplifier circuit 1000 may be configured to operate in accordance with input/gate signals and output signals provided herein (e.g. in accordance with aspects of the amplifier circuit 800, the amplifier circuit 900). The amplifier circuit 1000 includes a plurality of transistors connected in series for providing a circuit output signal to drive a capacitor of an SCDPA from an output terminal 1050. The amplifier circuit 1000 may receive a first input signal 1007 with a range of VDm, the first input signal 1007 (e.g. first digital signal) varying between a first upper voltage level of 4xVDm and a first lower voltage level of 3xVDm. The amplifier circuit 1000 may receive a second input signal 1008 with a range of VDm, the second input signal 1008 (e.g. second digital signal) varying between a second upper voltage level of VDm and a second lower voltage level of 0V. A level shifter may provide the first input signal 1007 and the second input signal 1008. A voltage supplier may provide a supply voltage 1001 of 4xVDm (depicted as vdd_4x) to a first end of the series connection. Second end of the series connection may be connected to the ground 1009 to provide a Vss voltage (depicted as vsspa in the figure).

The notation provided herein associated with VDm may be considered to represent a voltage level associated with the supply voltage. In this illustration, the voltage VDm is depicted sometimes as vdd, and sometimes as bias (e.g. bias_2x representing 2xVDm, bias_1x representing VDm, bias_3x representing 3xVDm). In consideration of aspects associated with providing optimum voltage output, the supply voltage NxVDm may be NxVDmax, VDmax being the maximum operation voltage (e.g. drain-source voltage) of each transistor of the plurality of transistors in the series connection. In some aspects, the corresponding signal levels provided to gates of each of the transistors in the series connection may also be considered in a manner that VDm=VDmax. In some aspects, VDm may be smaller than VDmax.

The plurality of transistors of the amplifier circuit 1000 may include transistors of a first conductivity type, which are provided herein as p-type transistors for exemplary purposes, including a first p-type transistor 1011, a second p-type transistor 1012, a third p-type transistor 1013, and a fourth p-type transistor 1014. The plurality of transistors of the amplifier circuit 1000 may include transistors of a second conductivity type, which are provided herein as n-type transistors for exemplary purposes, including a first n-type transistor 1021, a second n-type transistor 1022, a third n-type transistor 1023, and a fourth n-type transistor 1024.

Analogous to aspects provided in accordance with FIG.8 and 9, and following a similar notation and configuration, the first p-type transistor 1011 and the first n-type transistor 1021 may receive the first input signal 1007 and the second input signal 1008 respectively from their gates. The first p-type transistor 1011 may be configured to receive the supply voltage 1001 with its source terminal. The first n-type transistor 1021 may be connected to the ground 1009 with its source terminal. The output terminal 1050 of the amplifier circuit 1000 may be coupled to the drain of the second p-type transistor 1012 and the second n-type transistor 1022. The fourth p-type transistor 1014 is coupled, via its source, to the drain of the first p-type transistor 1011. The third p-type transistor 1013 is coupled, via its source, to the drain of the fourth p-type transistor 1014. The second p-type transistor 1012 is coupled, via its source, to the drain of the third p-type transistor 1013. The fourth n-type transistor 1024 is coupled, via its source, to the drain of the first n-type transistor 1021. The third n-type transistor 1023 is coupled, via its source, to the drain of the fourth n-type transistor 1024. The second n-type transistor 1022 is coupled, via its source, to the drain of the third n-type transistor 1013. The gate of the fourth p-type transistor 1014 may be connected to a first DC supply 1004 configured to provide a DC voltage of 3xVDm. The gate of the fourth n-type transistor 1024 may be connected to a second DC supply 1005 configured to provide a DC voltage of VDm.

Bulk voltages of the p-type transistors 1011, 1012, 1013, 1014 may be 4xVDm and bulk voltages of the n-type transistors 1021, 1022, 1023, 1024 may be Vss. Similarly, voltages applied to bulk terminals of further p-type transistors in the amplifier circuit 1000 may be 4xVDm, and voltages applied to bulk terminals of further n-type transistors in the amplifier circuit 1000 may be Vss.

In accordance with various aspects provided herein, the amplifier circuit 1000 may include components configured to drive inner transistors including the second p-type transistor 1012, the second n-type transistor 1022, the third p-type transistor 1013, the third n-type transistor 1023, namely transistors other than the transistors driven with external input signals (e.g. the first input signal and the second input signal) or the transistors driven with a DC supply. The components may be configured to drive the inner transistors, such that the corresponding operation voltage of each of the inner transistors would be equal to VDmax or less than VDmax, VDmax being the maximum operation voltage (e.g. drain-source voltage) of the respective inner transistor.

Referring back to voltage swings illustrated in FIG. 8, inconsideration of the voltage swings at the drain terminal of the first p-type transistor 1011 and the first n-type transistor, and the voltage swings of the inner transistors 1012, 1013, 1022, 1023, which the aspects of the voltage swings are further provided in the following sections, the fourth p-type transistor 1014 and the fourth n-type transistor 1024 may be supplied by DC voltage, and the drain-source voltage of each of the fourth p-type transistor 1014 and the fourth n-type transistor 1024 may be equal to VDmax or below.

As depicted herein, the amplifier circuit 1000 may include inner drivers that are configured to drive the inner transistors 1012, 1013, 1022, 1023, such that the voltage swing at the drain-source of each inner transistor 1012, 1013, 1022, 1023 would be maximum at VDmax over time. The inner drivers may drive the inner transistors 1012, 1013, 1022, 1023 based on one or more voltage levels at the series connection of the amplifier circuit 1000, in particular the voltage levels of the output signal.

In this illustrative example, inner drivers are implemented with a first circuit including first feedback transistors 1030a-b, first pull-up transistors 1031a-b, and first pull-down transistors 1032a-b, which are for the third p-type transistor 1013 and the third n-type transistor 1023. The inner drivers are further implemented with a second circuit including second feedback transistors 1040a-b, second pull-up transistors 1040a-b, and second pull-down transistors, which are for the second p-type transistor 1012 and the second n-type transistor 1022.

Starting from the second circuit, the second circuit may include the second feedback transistors 1040a-b. The p-type feedback transistor 1040a may be coupled, via its gate, to the gate of the second p-type transistor 1012. The n-type feedback transistor 1040b may be coupled, via its gate, to the gate of the second n-type transistor 1022. The second feedback transistors 1040a-b may receive a DC voltage of 2xVDm, via their drain and source terminals. Accordingly, the second feedback transistors 1040a-b may protect, via the capacitive feedback mechanism, the second p-type transistor 1012 and the second n-type transistor 1022. Sizes of each of the second feedback transistors 1040a-b may be half of the size of the second p-type transistor 1012 and/or the second n-type transistor 1022 to obtain a voltage range of 2:1 compared to the output signal of the amplifier circuit 1000.

The second circuit may further include second pull-up transistors 1041a-b to maintain the upper voltage level at the second p-type transistor 1012 and/or the second n-type transistor 1022. The drain of the first n-type pull-up transistor 1041a is coupled to a voltage source to receive a DC voltage of 3xVDm. The source of the first n-type pull-up transistor 1041a is coupled to the drain of the second n-type pull-up transistor 1041b. The gate of the first n-type pull-up transistor 1041a is coupled to the drain of the fourth p-type transistor 1014. The gate of the second n-type pull-up transistor 1041b is coupled to the drain of the third p-type transistor 1013. The source of the second n-type pull-up transistor 1041b is coupled to the gate of the second p-type transistor 1012. By dividing the voltage for pull-up operation with two transistors (i.e. first n-type pull-up transistor 1041a and second n-type pull-up transistor 1041b) in a 4-level stacking configuration, the drain-source voltages of the second pull-up transistors 1041a-b are also configured to be within a range of VDm. The second pull-up transistors 1041a-b may be at minimum size.

The second circuit may further include second pull-down transistors 1042a-b to maintain the lower voltage level at the second p-type transistor 1012 and/or the second n-type transistor 1022. The drain of the first p-type pull-down transistor 1042a is coupled to a voltage source to receive a DC voltage of VDm. The source of the first p-type pull-down transistor 1042a is coupled to the drain of the second p-type pull-down transistor 1042b. The gate of the first p-type pull-down transistor 1042a is coupled to the drain of the fourth n-type transistor 1024. The gate of the second p-type pull-down transistor 1042b is coupled to the drain of the third n-type transistor 1023. The source of the second p-type pull-down transistor 1042b is coupled to the gate of the second p-type transistor 1012. By dividing the voltage for pull-down operation into two transistors (i.e. first p-type pull-down transistor 1042a and second p-type pull-down transistor 1042b) in a 4-level stacking configuration, the drain-source voltages of the second pull-down transistors 1042a-b are also configured to be within a range of VDm.

The first circuit may include the first feedback transistors 1030a-b. The p-type feedback transistor 1030a may be coupled, via its gate, to the gate of the third p-type transistor 1013. The n-type feedback transistor 1030b may be coupled, via its gate, to the gate of the third n-type transistor 1023. The first feedback transistors 1030a-b may receive a DC voltage of 2xVDm, the via their drain and source terminals. Accordingly, the first feedback transistors 1030a-b may protect, via the capacitive feedback mechanism, the third p-type transistor 1013, and the third n-type transistor 1023.

The first circuit may further include the first pull-up transistors 1031a-b to maintain the upper voltage level, and first pull-down transistors 1032a-b to maintain the lower voltage level at the third p-type transistor 1013, and the third n-type transistor 1023. The first n-type pull-up transistor 1031a and the first pull-down transistor 1032a may maintain the drain-source voltage level of the third p-type transistor 1013 to be within a range of VDm. The second n-type pull-up transistor 1031b and the second p-type pull-down transistor 1032b may maintain the drain-source voltage of the third n-type transistor 1023 to be within a range of VDm.

The drain of the first n-type pull-up transistor 1031a is coupled to a voltage source to receive a DC voltage of 3xVDm. The source of the first n-type pull-up transistor 1031a is coupled to the source of the first p-type pull-down transistor 1032a and the gate of the third p-type transistor 1013. The gate of the first n-type pull-up transistor 1031a is coupled to the drain of the fourth p-type transistor 1014. The gate of the first p-type pull-down transistor 1032a is coupled to the gate of the second p-type transistor 1012. The drain of the first p-type pull-down transistor 1032a is coupled to a DC bias voltage of 2xVDm.

The drain of the first n-type pull-up transistor 1031a is coupled to a voltage source to receive a DC voltage of 3xVDm. The source of the first n-type pull-up transistor 1031a is coupled to the source of the first p-type pull-down transistor 1032a and the gate of the third p-type transistor 1013. The gate of the first n-type pull-up transistor 1031a is coupled to the drain of the fourth p-type transistor 1014. The gate of the first p-type pull-down transistor 1032a is coupled to the gate of the second p-type transistor 1012. The drain of the first p-type pull-down transistor 1032a is coupled to a DC bias voltage of 2xVDm.

The drain of the second n-type pull-up transistor 1031b is coupled to a voltage source to receive a DC voltage of 2xVDm. The source of the second n-type pull-up transistor 1031b is coupled to the source of the second p-type pull-down transistor 1032b and the gate of the third n-type transistor 1023. The gate of the second n-type pull-up transistor 1031b is coupled to the gate of the second n-type transistor 1022. The gate of the second p-type pull-down transistor 1032b is coupled to the drain of the fourth n-type transistor 1024. The drain of the second p-type pull-down transistor 1032b is coupled to a DC bias voltage of VDm.

By dividing the voltage for pull-down operation into two transistors (i.e. first p-type pull-down transistor 1042a and second p-type pull-down transistor 1042b) in a 4-level stacking configuration, the drain-source voltages of the second pull-down transistors 1042a-b are also configured to be within a range of VDm.

The gate of the second n-type pull-up transistor 1041b is coupled to the drain of the third p-type transistor 1013. The source of the second n-type pull-up transistor 1041b is coupled to the gate of the second p-type transistor 1012. By dividing the voltage for pull-up operation with two transistors in a 4-level stacking configuration, the drain-source voltages of the second pull-up transistors 1041a-b are also configured to be within a range of VDm. In some aspects, the first feedback transistors 1030a-b may have the same size as the third p-type transistor 1013 and the third n-type transistor 1023 to obtain the voltage ratio of 3 to 1.

Through the use of the first circuit and the second circuit, the voltage level between the drain-source terminals of the inner transistors 1012, 1013, 1022, 1023 to be maximum at VDm (e.g. VDmax). These circuits may cause the voltage level between the drain and the source to be maximum a upper voltage level and minimum a lower voltage level for each of the inner transistors, the difference of the upper voltage level and the lower voltage level being VDm.

The second circuit may provide a feedback signal to the gate of the second p-type transistor 1012 and the feedback signal to the gate of the second n-type transistor 1022. The feedback signal may be in-phase with the output signal of the amplifier circuit 1000, and proportional to the output signal of the amplifier circuit 1000. The second circuit may accordingly maintain the voltage swing of the drain-source of the second p-type transistor 1012 within a range of VDm (e.g. VDmax). The first circuit may provide a gate signal, such that the drain voltage (e.g. drain-ground 1009) of the second p-type transistor 1012 and the second n-type transistor 1022 may have the voltage swing of 4xVDm (e.g. 4xVDmax), while the drain-source voltage of the second p-type transistor 1012 and the second n-type transistor 1022 may be maximum at VDm.

Similarly, the first circuit may provide a first feedback signal to the gate of the third p-type transistor 1013 and a second feedback signal to the gate of the third n-type transistor 1023. The first feedback signal and the second feedback signal may be in-phase with the output signal of the amplifier circuit 1000, and proportional to the output signal of the amplifier circuit 1000. The first circuit may accordingly maintain the voltage swing of the drain-source of the third p-type transistor 1013 and the third n-type transistor 1023 within a range of VDm (e.g. VDmax). The first circuit may provide a first gate signal and a second gate signal, such that the drain voltage (e.g. drain-ground 1009) of each of the third p-type transistor 1013 and the third n-type transistor 1023 may have a voltage swing of 2xVDm (e.g. 2xVDmax), while the drain-source voltage of the second p-type transistor 1012 and the second n-type transistor 1022 may be maximum at VDm.

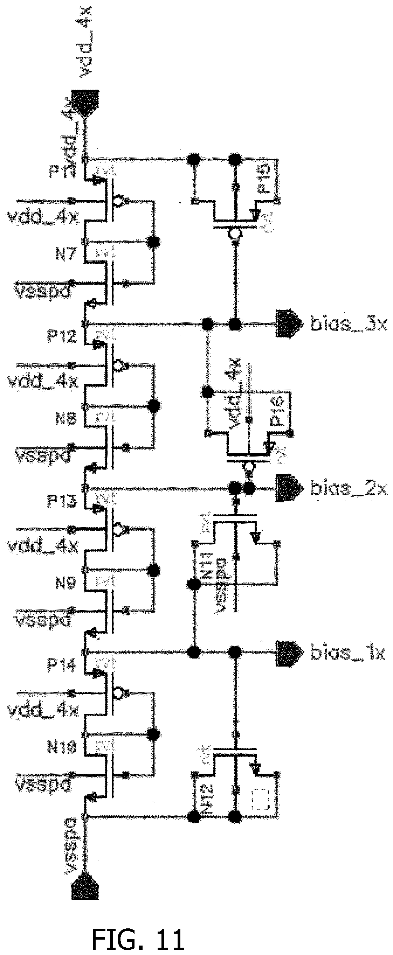

FIG. 11 illustrates a voltage supply circuit in accordance with various aspects of this disclosure. The voltage supply circuit 1100 is complementary to the amplifier circuit illustrated in FIG. 10. Therefore, the terminology used in these FIGs to mark voltage levels are compliant with each other. In other words, vdd_4x may represent a voltage level of 4xVDm, bias_1x may represent a voltage level of VDm, bias_2x may represent a voltage level of 2xVDm, bias_3x may represent a voltage level of 3xVDm, vsspa may represent a voltage level of Vss (e.g. 0V). In consideration of aspects associated with providing optimum voltage output, the supply voltage NxVDm may be NxVDmax, VDmax being the maximum operation voltage (e.g. drain-source voltage) of each transistor of the plurality of transistors in the series connection. In some aspects, the corresponding signal levels provided to gates of each of the transistors in the series connection may also be considered in a manner that VDm=VDmax. In some aspects, VDm may be smaller than VDmax.

The voltage supply circuit 1100 may be configured to receive a supply voltage of 4xVDm and may output voltages at levels 3xVDm, 2xVDm, and VDm, to be used for the amplifier circuit 1000. A voltage supplier or a level shifter may provide the supply voltage of 4xVDm. In one example, the amplifier circuit 1000 and the voltage supply circuit may be coupled to the voltage supplier or the level shifter in a parallel configuration. The voltage supply circuit 1100 using a bias totem with de-caps may allow only minimal current support. Accordingly, an LDO or DC2DC circuit may not be needed.

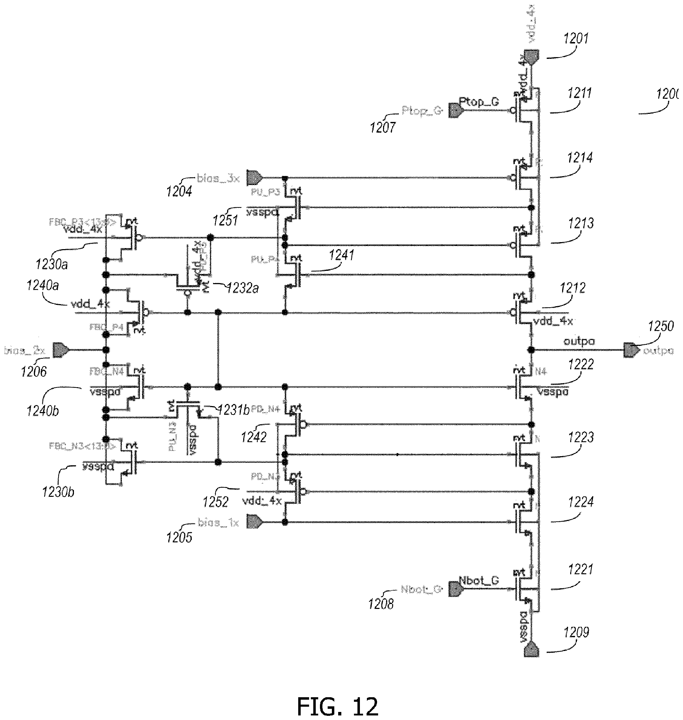

FIG. 12 shows an example of an amplifier circuit. It is noted that the amplifier circuit 1200 provided herein is similar to the amplifier circuit provided in accordance with FIG. 10. The notations and reference numbers provided for FIG. 10 match the notations and reference numbers provided for the amplifier circuit 1200. Accordingly, the aspects explained in accordance with FIG. 10 are applicable to the amplifier circuit 1200.

The illustrated amplifier circuit 1200 is an example of an amplifier circuit with 4-level stacking. The amplifier circuit 1200 includes a plurality of transistors connected in series for providing a circuit output signal to drive a capacitor of an SCDPA from an output terminal 1250. The amplifier circuit 1200 may receive a first input signal 1207 with a range of VDm, the first input signal 1207 (e.g. first digital signal) varying between a first upper voltage level of 4xVDm and a first lower voltage level of 3xVDm. The amplifier circuit 1200 may receive a second input signal 1208 with a range of VDm, the second input signal 1208 (e.g. second digital signal) varying between a second upper voltage level of VDm and a second lower voltage level of 0V. A voltage supplier may provide a supply voltage 1001 of 4xVDm (depicted as vdd_4x) to a first end of the series connection. Second end of the series connection may be connected to the ground 1009 to provide a Vss voltage (depicted as vsspa in the figure).

The notation provided herein associated with VDm may be considered to represent a voltage level associated with the supply voltage. In this illustration, the voltage VDm is depicted sometimes as vdd, and sometimes as bias (e.g. bias_2x representing 2xVDm, bias_1x representing VDm, bias_3x representing 3xVDm). In consideration of aspects associated with providing optimum voltage output, the supply voltage NxVDm may be NxVDmax, VDmax being the maximum operation voltage (e.g. drain-source voltage) of each transistor of the plurality of transistors in the series connection. In some aspects, the corresponding signal levels provided to gates of each of the transistors in the series connection may also be considered in a manner that VDm=VDmax. In some aspects, VDm may be smaller than VDmax.

The plurality of transistors of the amplifier circuit 1200 may include transistors of a first conductivity type, which are provided herein as p-type transistors for exemplary purposes, including a first p-type transistor 1211, a second p-type transistor 1212, a third p-type transistor 1213, and a fourth p-type transistor 1214. The plurality of transistors of the amplifier circuit 1200 may include transistors of a second conductivity type, which are provided herein as n-type transistors for exemplary purposes, including a first n-type transistor 1221, a second n-type transistor 1222, a third n-type transistor 1223, and a fourth n-type transistor 1224.

In this illustrative example, inner drivers are implemented with a first circuit including first feedback transistors 1230a-b for the third p-type transistor 1213 and the third n-type transistor 1223, and a second circuit including second feedback transistors 1240a-b for the second p-type transistor 1212 and the second n-type transistor 1222.

In this illustrated circuit configuration with reference to the amplifier circuit 1000, the first n-type pull-up transistor 1031a of the first circuit and the first n-type pull-up transistor 1041a of the second circuit are combined. Accordingly, pull-up transistors of the first circuit and pull-up transistors of the second circuit are formed with a first n-type pull-up transistor 1241 and a second n-type pull-up transistor 1251 in the amplifier circuit 1200. Similarly, referencing the amplifier circuit 1000, the first p-type pull-down transistor 1042a of the second circuit and the second p-type pull-down transistor 1032b of the first circuit are combined. Accordingly, pull-down transistors of the first circuit and pull-down transistors of the second circuit are formed with a first p-type pull-down transistor 1242, and a second p-type pull-down transistor 1252.

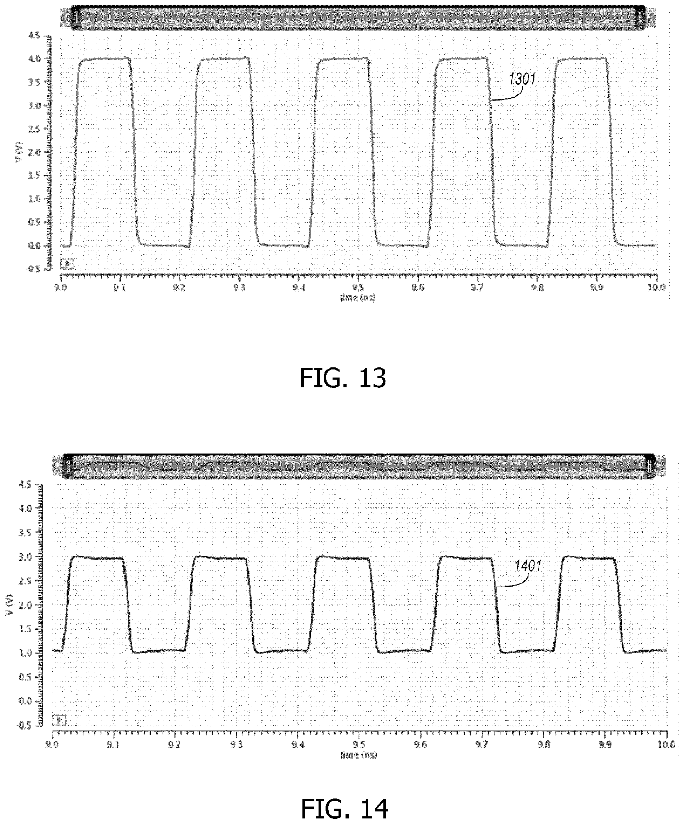

FIG. 13 shows a simulated representation of a waveform in an amplifier circuit. In the graph 1300, a voltage over time representation 1301 of the output signal of the amplifier circuit 900 is provided, illustrating that the output signal has a peak-to-peak amplitude of approximately 4 Volts, varying between a lower voltage level of 0 V and an upper voltage level of 4 V. The time axis indicates the output signal is illustrated for a period of time between 9 ns and 10 ns.

FIG. 14 shows a simulated representation of a waveform in an amplifier circuit. In the graph, a voltage over time representation 1401 of the gate signal of the second n-type transistor 922 of the amplifier circuit 900 is provided, illustrating that the gate signal has a peak-to-peak amplitude of approximately 2 Volts that is in phase with the output signal represented in FIG. 13, and proportional to the output signal with 1/2. The illustrated gate signal varies between a lower voltage level of 1 V and an upper voltage level of 3 V. The time axis indicates the illustrated gate signal is provided for a period of time between 9 ns and 10 ns.

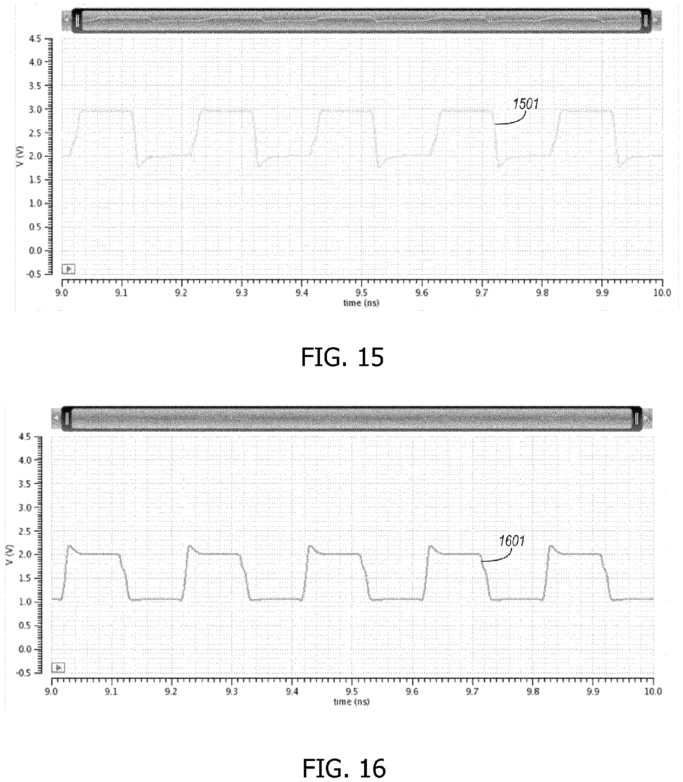

FIG. 15 shows a simulated representation of a waveform in an amplifier circuit. In the graph, a voltage over time representation 1501 of the gate signal of the third p-type transistor 913 of the amplifier circuit 900 is provided, illustrating that the gate signal has a peak-to-peak amplitude of approximately 1 Volt that is in phase with the output signal represented in FIG. 13, and proportional to the output signal with 1/3. The illustrated gate signal varies between a lower voltage level of 2 V and an upper voltage level of 3 V. The time axis indicates the illustrated gate signal is provided for a period of time between 9 ns and 10 ns.

FIG. 16 shows a simulated representation of a waveform in an amplifier circuit. In the graph, a voltage over time representation 1601 of the gate signal of the third n-type transistor 923 of the amplifier circuit 900 is provided, illustrating that the gate signal has a peak-to-peak amplitude of approximately 1 Volt that is in phase with the output signal represented in FIG. 13, and proportional to the output signal with 1/3. The illustrated gate signal varies between a lower voltage level of 1 V and an upper voltage level of 2 V. The time axis indicates the illustrated gate signal is provided for a period of time between 9 ns and 10 ns.

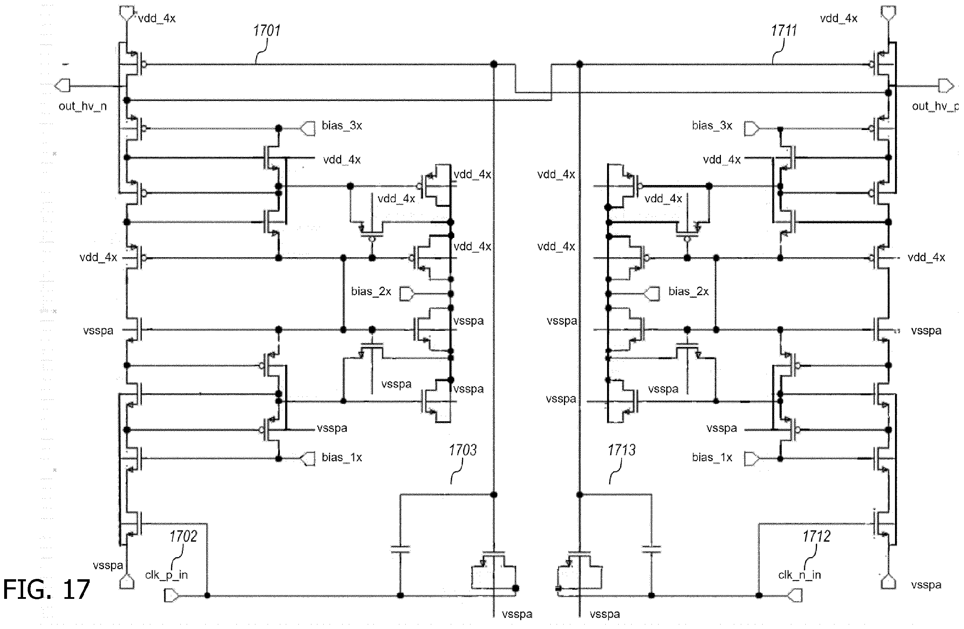

FIG. 17 shows a level shifter with capacitive boot strapping. A level shifter may translate input voltage to a desired output voltage that is higher than the input voltage. The illustrated level shifter circuit may include a first amplifier circuit including the amplifier circuit 1200 and a second amplifier circuit including the amplifier circuit 1200 provided with respect to FIG. 12. In this illustrative example, the level shifter may receive the respective first input signals and the respective second input signals for the first amplifier circuit and the second amplifier circuit. The notations and reference numbers provided for FIG. 12 for the amplifier circuit match the notations and reference numbers provided for FIG. 17. Accordingly, the aspects explained in accordance with FIG. 12 are applicable to the level shifter circuit.

The illustrated level shifter circuit includes amplifier circuits provided in FIG. 12 with 4-level stacking connected as depicted. The first amplifier circuit of the level shifter circuit may receive a first input signal 1701 with a range of VDm, the first input signal 1701 (e.g. first digital signal) varying between a first upper voltage level of 4xVDm and a first lower voltage level of 3xVDm. The first amplifier circuit may receive a second input signal 1702 with a range of VDm, the second input signal 1702 (e.g. second digital signal) varying between a second upper voltage level of VDm and a second lower voltage level of 0V. A voltage supplier may provide a supply voltage of 4xVDm (depicted as vdd_4x) to a first end of the series connection. Second end of the series connection may be connected to the ground to provide a Vss voltage (depicted as vsspa in the figure).

Similarly, the second amplifier circuit of the level shifter circuit may receive a first input signal 1711 with a range of VDm, the first input signal 1711 (e.g. first digital signal) varying between a first upper voltage level of 4xVDm and a first lower voltage level of 3xVDm. The second amplifier circuit may receive a second input signal 1702 with a range of VDm, the second input signal 1702 (e.g. second digital signal) varying between a second upper voltage level of VDm and a second lower voltage level of 0V. A voltage supplier may provide a supply voltage of 4xVDm (depicted as vdd_4x) to a first end of the series connection. Second end of the series connection may be connected to the ground to provide a Vss voltage (depicted as vsspa in the figure).

The notation provided herein associated with VDm may be considered to represent a voltage level associated with the supply voltage. In this illustration, the voltage VDm is depicted sometimes as vdd, and sometimes as bias (e.g. bias_2x representing 2xVDm, bias_1x representing VDm, bias_3x representing 3xVDm). In consideration of aspects associated with providing optimum voltage output, the supply voltage NxVDm may be NxVDmax, VDmax being the maximum operation voltage (e.g. drain-source voltage) of each transistor of the plurality of transistors in the series connection. In some aspects, the corresponding signal levels provided to gates of each of the transistors in the series connection may also be considered in a manner that VDm=VDmax. In some aspects, VDm may be smaller than VDmax.

In this configuration, a MOLO may generate respective input signals to provide the respective input signals to the clk_p_in and clk_n_in terminals. Accordingly, the second input signal 1702 of the first amplifier circuit and the second input signal 1712 of the second amplifier circuit may be provided. The level shifter circuit may include a first circuit 1703 and a second circuit 1713 The first circuit 1703 may be configured to shift the amplitude of the second input signal 1702 of the first amplifier circuit to obtain the first input signal 1701 of the first amplifier circuit in accordance with exemplary first input signals and second input signals provided in this disclosure. Similarly, the second circuit 1733 may be configured to shift the amplitude of the second input signal 1712 of the second amplifier circuit to obtain the first input signal 1711 of the second amplifier circuit in accordance with exemplary first input signals and second input signals provided in this disclosure.

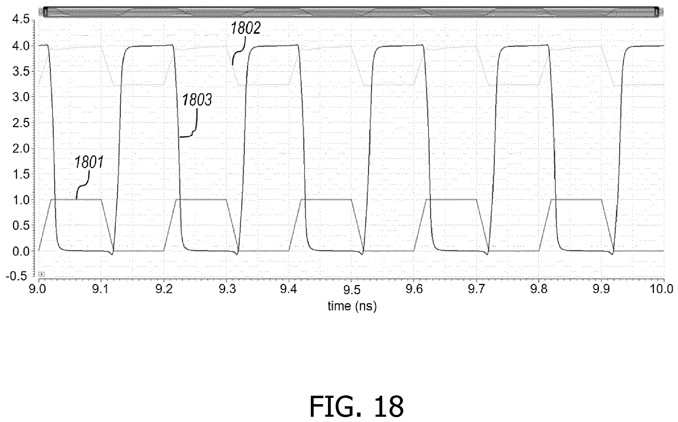

FIG. 18 shows an exemplary graph representing the signals of a level shifter circuit. The graph illustrates single-ended input signals and output of the level shifter circuit illustrated in FIG. 17. It is illustrated the first input signal 1801 varies between approximately 0 V and 1 V, the second input signal 1802 varies between approximately 3.2 V and 4 V, and the output signal 1803 varying between approximately 0 V and 4 V.

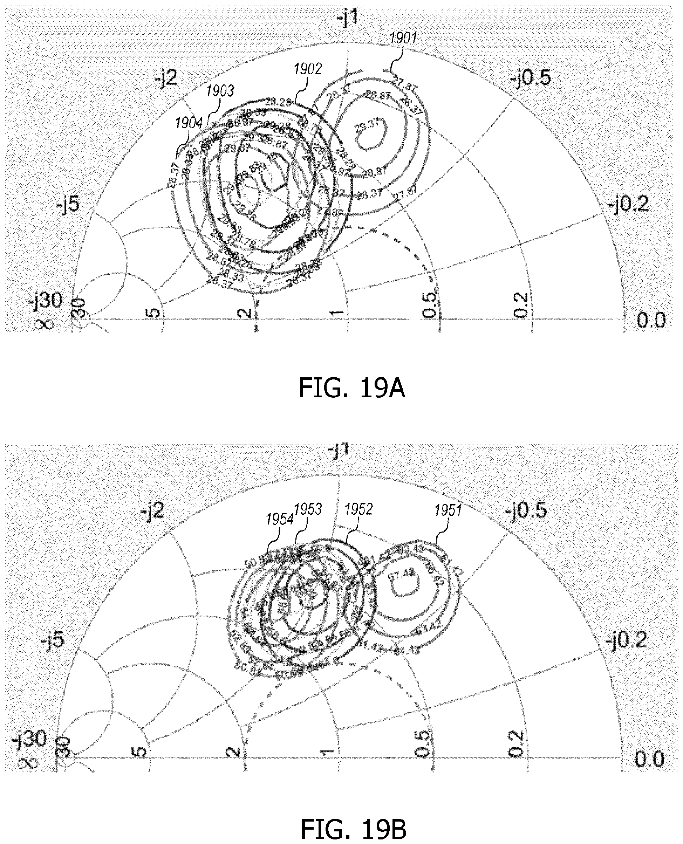

FIG. 19A and 19B show load-pull results of an amplifier circuit with 4-level stacking provided in accordance with various aspects herein. The load-pull results may be considered as initial and un-optimized and only the half of the charts representing the load-pull results are provided for brevity. The Figures collectively illustrate load-pull results a maximum output power 1901 and efficiency 1951 for a 2.5 GHz signal, a maximum output power 1902 and efficiency 1952 for a 5 GHz signal, a maximum output power 1903 and efficiency 1953 for a 6 GHz signal, and a maximum output power 1904 and efficiency 1954 for a 7 GHz signal.

The detailed description refers to the accompanying drawings that show, by way of illustration, specific details and aspects of this disclosure in which the disclosure may be practiced. Other aspects may be utilized and structural, logical, and electrical changes may be made without departing from the scope of the disclosure. The various aspects of this disclosure are not necessarily mutually exclusive, as some aspects of this disclosure can be combined with one or more other aspects of this disclosure to form new aspects.

The word "exemplary" is used herein to mean "serving as an example, instance, or illustration". Any aspect of the disclosure or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in a plural form that does not expressly state "plurality" or "multiple" likewise refers to a quantity equal to or greater than one.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

In the context of this disclosure, the term "process" may be used, for example, to indicate a method. Illustratively, any process described herein may be implemented as a method (e.g., a channel estimation process may be understood as a channel estimation method). Any process described herein may be implemented as a non-transitory computer readable medium including instructions configured, when executed, to cause one or more processors to carry out the process (e.g., to carry out the method).

"The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. The terms "group (of)", "set (of)", "collection (of)", "series (of)", "sequence (of)", "grouping (of)", etc., and the like in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

As used herein, unless otherwise specified the use of the ordinal adjectives "first", "second", "third" etc., to describe a common object, merely indicate that different instances of like objects are being referred to, and are not intended to imply that the objects so described must be in a given sequence, either temporally, spatially, in ranking, or in any other manner.

As used herein, a signal that is "indicative of" a value or other information may be a digital or analog signal that encodes or otherwise communicates the value or other information in a manner that can be decoded by and/or cause a responsive action in a component receiving the signal. The signal may be stored or buffered in computer readable storage medium prior to its receipt by the receiving component and the receiving component may retrieve the signal from the storage medium. Further, a "value" that is "indicative of" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As utilized herein, terms "module", "component," "system," "circuit," "element," "slice," "circuitry," and the like are intended to refer to a set of one or more electronic components, a computer-related entity, hardware, software (e.g., in execution), and/or firmware. For example, circuitry or a similar term can be a processor, a process running on a processor, a controller, an object, an executable program, a storage device, and/or a computer with a processing device. By way of illustration, an application running on a server and the server can also be circuitry. One or more circuits can reside within the same circuitry, and circuitry can be localized on one computer and/or distributed between two or more computers. A set of elements or a set of other circuits can be described herein, in which the term "set" can be interpreted as "one or more."

The term "antenna" or "antenna structure", as used herein, may include any suitable configuration, structure and/or arrangement of one or more antenna elements, components, units, assemblies and/or arrays. In some aspects, the antenna may implement transmit and receive functionalities using separate transmit and receive antenna elements. In some aspects, the antenna may implement transmit and receive functionalities using common and/or integrated transmit/receive elements. The antenna may include, for example, a phased array antenna, a single element antenna, a set of switched beam antennas, and/or the like.

It will be understood that when an element is referred to as being "connected" or "coupled" to another element, it can be physically connected or coupled to the other element such that current and/or electromagnetic radiation (e.g., a signal) can flow along a conductive path formed by the elements. Intervening conductive, inductive, or capacitive elements may be present between the element and the other element when the elements are described as being coupled or connected to one another. Further, when coupled or connected to one another, one element may be capable of inducing a voltage or current flow or propagation of an electromagnetic wave in the other element without physical contact or intervening components. Further, when a voltage, current, or signal is referred to as being "applied" to an element, the voltage, current, or signal may be conducted to the element by way of a physical connection or by way of capacitive, electro-magnetic, or inductive coupling that does not involve a physical connection.

In example 1, the subject matter includes an amplifier circuit that may include: a plurality of transistors connected in series, the plurality of transistors may include: a first transistor of a first conductivity type , a second transistor of the first conductivity type, and a third transistor of the first conductivity type coupled to the first transistor of the first conductivity type and the second transistor of the first conductivity type, the first transistor of the first conductivity type may include a control terminal configured to receive a first signal varying between a first upper voltage level and a first lower voltage level; a first transistor of a second conductivity type , a second transistor of the second conductivity type, and a third transistor of the second conductivity type coupled to the first transistor of the second conductivity type and the second transistor of the second conductivity type, the first transistor of the second conductivity type may include a control terminal configured to receive a second signal varying between a second upper voltage level and a second lower voltage level; an output terminal coupled to the second transistor of the first conductivity type and the second transistor of the second conductivity type, the output terminal is configured to provide an output signal varying between the first upper voltage level and the second lower voltage level; a feedback circuit configured to provide signals that are in phase with the output signal to a control terminal of the third transistor of the first conductivity type and to a control terminal of the third transistor of the second conductivity type.

In example 2, the subject matter of example 1, can optionally include that the feedback circuit is configured to generate feedback signals to control the operation of the third transistor of the first conductivity type and the third transistor of the second conductivity type.

In example 3, the subject matter of example 2, can optionally include that the generated feedback signals to control the operation of the third transistor of the first conductivity type and the third transistor of the second conductivity type are based on output voltages of the third transistor of the first conductivity type and the third transistor of the second conductivity type respectively.

In example 4, the subject matter of any one of examples 1 to 3, can optionally include that the capacitive divider feedback circuit includes: a first feedback transistor of the first conductivity type may include a control terminal coupled to the control terminal of the third transistor of the first conductivity type; and a first feedback transistor of the second conductivity type may include a control terminal coupled to the control terminal of the third transistor of the second conductivity type.

In example 5, the subject matter of example 4, can optionally include that the feedback circuit includes a first keeper circuit coupled to the third transistor of the first conductivity type and the first feedback transistor of the first conductivity type, the keeper circuit is configured to cause a drain-source voltage of the third transistor of the first conductivity type to be between a third upper voltage level and a third lower voltage level.

In example 6, the subject matter of example 5, can optionally include that the first keeper circuit includes a first pull-up transistor and a first pull-down transistor, the first pull-up transistor may include a control terminal coupled to the output terminal of the third transistor of the first conductivity type.

In example 7, the subject matter of example 5 or example 6, can optionally include that the feedback circuit includes a second keeper circuit coupled to the third transistor of the second conductivity type and the first feedback transistor of the first conductivity type, the second keeper circuit is configured to cause a drain-source voltage of the third transistor of the second conductivity type to be between a fourth upper voltage level and a fourth lower voltage level.

In example 8, the subject matter of example 7, can optionally include that the fourth upper voltage level and the fourth lower voltage level equal to the third upper voltage level and the third lower voltage level respectively.

In example 9, the subject matter of example 7 or example 8, can optionally include that the second keeper circuit includes a second pull-up transistor and a second pull-down transistor, the second pull-up transistor may include a gate terminal coupled to the drain terminal of the third transistor of the second conductivity type.

In example 10, the subject matter of any one of examples 1 to 9, can optionally include that the plurality of transistors includes: a fourth transistor of the first conductivity type coupled to the first transistor of the first conductivity type and the third transistor of the first conductivity type (e.g. coupled between the first transistor of the first conductivity type and the third transistor of the first conductivity type), the fourth transistor of the first conductivity type may include a gate terminal configured to receive a first DC signal at the first lower voltage level.

In example 11, the subject matter of any one of examples 1 to 10, can optionally include that a first gate signal received by the gate terminal of the third transistor of the first conductivity type varies between the first lower voltage level and a voltage level that is greater than the second upper voltage level.

In example 12, the subject matter of example 11, can optionally include that the first gate signal and the output signal are in phase.

In example 13, the subject matter of any one of examples 1 to 12, can optionally include that the plurality of transistors includes: a fourth transistor of the second conductivity type coupled to the first transistor of the second conductivity type and the third transistor of the second conductivity type (e.g. coupled between the first transistor of the second conductivity type and the third transistor of the second conductivity type), the fourth transistor of the second conductivity type may include a gate terminal configured to receive a second DC signal at the second upper voltage level.

In example 14, the subject matter of example 13, can optionally include that a second gate signal received by the gate terminal of the third transistor of the second conductivity type varies between the second upper voltage level and a voltage level that is smaller than the first lower voltage level.

In example 15, the subject matter of example 14, can optionally include that the second gate signal and the output signal are in phase.

In example 16, the subject matter of any one of examples 1 to 15, can optionally include that gate terminals of the second transistor of the first conductivity type and the second transistor of the second conductivity type are coupled to a common gate terminal that is configured to receive a common gate signal that is variable between the first lower voltage level and the second upper voltage level.

In example 17, the subject matter of example 16, can optionally include that the common gate signal and the output signal are in phase.

In example 18, the subject matter of any one of examples 1 to 17, can optionally include that the feedback circuit being a first capacitive divider feedback circuit; can optionally include that the amplifier circuit further includes a second capacitive divider feedback circuit coupled to the gate terminal of the second transistor of the first conductivity type and the gate terminal of the second transistor of the second conductivity type.

In example 19, the subject matter of example 18, can optionally include that the second capacitive divider feedback circuit is configured to generate second feedback signals to control the operation of the second transistor of the first conductivity type and the second transistor of the second conductivity type.

In example 20, the subject matter of example 18 or example 19, can optionally include that output signal is based on a feedback capacitive ratio defined by the second capacitive divider feedback circuit.

In example 21, the subject matter of any one of examples 18 to 20, can optionally include that size of each of the second transistor of the first conductivity type and the second transistor of the second conductivity type is of a first size; can optionally include that second capacitive divider feedback circuit includes feedback transistors having a second size, the second size is half of the first size.

In example 22, the subject matter of any one of examples 18 to 21, can optionally include that the second capacitive divider feedback circuit includes a keeper circuit configured for the second transistor of the first conductivity type and the second transistor of the second conductivity type.

In example 23, the subject matter of example 22, can optionally include that the keeper circuit of the second capacitive divider feedback circuit includes the first pull-up transistor and the second pull-down transistor.

In example 24, the subject matter of any one of examples 18 to 23, can optionally include that the generated second feedback signals to control the operation of the second transistor of the first conductivity type and the second transistor of the second conductivity type are based on output voltages of the second transistor of the first conductivity type and the second transistor of the second conductivity type respectively.

In example 25, the subject matter of any one of examples 1 to 24, can optionally include that the plurality of transistors includes: one or more further transistors of the first conductivity type coupled to the first transistor of the first conductivity type and the second transistor of the first conductivity type (e.g. coupled between the first transistor of the first conductivity type and the second transistor of the first conductivity type); one or more further transistors of the second conductivity type coupled to the first transistor of the second conductivity type and the second transistor of the second conductivity type (e.g. coupled between the first transistor of the second conductivity type and the second transistor of the second conductivity type).

In example 26, the subject matter of example 25, may further include one or more further capacitive divider feedback circuits, each further capacitive divider feedback circuit is configured for a pair of the one or more further transistors of the first conductivity type and the one or more further transistors of the second conductivity type.

In example 27, the subject matter of any one of examples 1 to 26, can optionally include that a peak-to-peak amplitude of the first signal is equal to a peak-to-peak amplitude of the second signal.

In example 28, the subject matter of example 27, can optionally include that each transistor of the plurality of transistors is configured to operate with a maximum operation voltage that is equal or smaller than a voltage represented by the peak-to-peak amplitude of the first signal or the second signal.

In example 29, the subject matter of any one of examples 1 to 28, can optionally include that the amplifier circuit is an amplifier circuit in an N-level stacking configuration, can optionally include that N is an integer greater than 3.

In example 30, the subject matter of any one of examples 1 to 29, can optionally include that the amplifier circuit includes a power amplifier driver circuit may include the plurality of transistors and a switched capacitor amplifier driven by the power amplifier driver circuit.

In example 31, the subject matter of any one of examples 1 to 30, may further include a level shifter circuit configured to generate the first signal and the second signal.

In example 32, the subject matter of any one of examples 1 to 31, can optionally include that the transistors of the first conductivity type are p-type transistors and the transistors of the second conductivity type are n-type transistors.

In example 33, the amplifier circuit of any one of examples 1 to 32, may further include any of the aspects provided in the description.

In example 34, the subject matter includes an amplifier circuit that may include: a plurality of transistors connected in series, the plurality of transistors may include: a first p-type transistor, a second p-type transistor, and a third p-type transistor coupled to the first p-type transistor and the second p-type transistor (e.g. coupled between the first p-type transistor and the second p-type transistor), the first p-type transistor may include a gate terminal configured to receive a first signal varying between a first upper voltage level and a first lower voltage level; a first n-type transistor, a second n-type transistor, and a third n-type transistor coupled to the first n-type transistor and the second n-type transistor (e.g. coupled between the first n-type transistor and the second n-type transistor), the first n-type transistor may include a gate terminal configured to receive a second signal varying between a second upper voltage level and a second lower voltage level; an output terminal coupled to the second p-type transistor and the second n-type transistor, the output terminal is configured to provide an output signal varying between the first upper voltage level and the second lower voltage level; a capacitive divider feedback circuit coupled to a gate terminal of the third p-type transistor and a gate terminal of the third n-type transistor.

In example 35, the subject matter of example 34 may further include any one of the aspects provided in this description, in particular aspects indicated in any one of the examples 2 to 33.

In example 36, the subject matter includes an amplifier circuit that may include: a plurality of transistors configured to drive a switched capacitor digital power amplifier, the plurality of transistors may include: a first p-type transistor, a second p-type transistor, and a third p-type transistor connected between the first p-type transistor and the second p-type transistor, a gate of the first p-type transistor is configured to receive a first signal within a first voltage range varying between a first upper voltage level and a first lower voltage level; a first n-type transistor, a second n-type transistor, and a third n-type transistor connected between the first n-type transistor and the second n-type transistor, a gate of the first n-type transistor is configured to receive a second signal within a second voltage range varying between a second upper voltage level and a second lower voltage level; an output connected to the second p-type transistor and the second n-type transistor, the output is configured to provide an output signal within a third voltage range varying between the first upper voltage level and the second lower voltage level; a feedback circuit configured to provide signals that are in phase and proportional to the output signal to a gate terminal of the third p-type transistor and a gate terminal of the third n-type transistor.

In example 37 the subject matter of example 36 may further include any one of the aspects provided in this description, in particular aspects indicated in any one of the examples 2 to 33.

In example 38, the subject matter includes an amplifier circuit that may include: a plurality of transistors connected in series, the plurality of transistors may include: a first p-type transistor, a second p-type transistor, and a third p-type transistor coupled to the first p-type transistor and the second p-type transistor (e.g. coupled between the first p-type transistor and the second p-type transistor), the first p-type transistor may include a gate terminal configured to receive a first signal varying between a first upper voltage level and a first lower voltage level; a first n-type transistor, a second n-type transistor, and a third n-type transistor coupled to the first n-type transistor and the second n-type transistor (e.g. coupled between the first n-type transistor and the second n-type transistor), the first n-type transistor may include a gate terminal configured to receive a second signal varying between a second upper voltage level and a second lower voltage level; an output means coupled to the second p-type transistor and the second n-type transistor, the output terminal is configured to provide an output signal varying between the first upper voltage level and the second lower voltage level; a feedback means coupled to a gate terminal of the third p-type transistor and a gate terminal of the third n-type transistor.

In example 39, the subject matter of example 38 may further include means to realize any one of the aspects provided in this description, in particular aspects indicated in any one of examples 2 to 33.

## Claims

1. An amplifier circuit comprising:
a plurality of transistors connected in series, the plurality of transistors comprising:
a first transistor of a first conductivity type, a second transistor of the first conductivity type, and a third transistor of the first conductivity type coupled to the first transistor of the first conductivity type and the second transistor of the first conductivity type, the first transistor of the first conductivity type comprising a control terminal to receive a first signal varying between a first upper voltage level and a first lower voltage level;
a first transistor of a second conductivity type, a second transistor of the second conductivity type, and a third transistor of the second conductivity type coupled to the first transistor of the second conductivity type and the second transistor of the second conductivity type, the first transistor of the second conductivity type comprising a control terminal to receive a second signal varying between a second upper voltage level and a second lower voltage level;
an output terminal coupled to the second transistor of the first conductivity type and the second transistor of the second conductivity type, the output terminal is configured to provide an output signal varying between the first upper voltage level and the second lower voltage level;
a feedback circuit configured to provide signals that are in phase with the output signal to a control terminal of the third transistor of the first conductivity type and to a control terminal of the third transistor of the second conductivity type.

2. The amplifier circuit of claim 1,
wherein the feedback circuit is configured to generate feedback signals to control the operation of the third transistor of the first conductivity type and the third transistor of the second conductivity type.

3. The amplifier circuit of claim 2,
wherein the generated feedback signals to control the operation of the third transistor of the first conductivity type and the third transistor of the second conductivity type are based on output voltages of the third transistor of the first conductivity type and the third transistor of the second conductivity type respectively.

4. The amplifier circuit of any one of claims 1 to 3,
wherein the feedback circuit comprises:
a first feedback transistor of the first conductivity type comprising a control terminal coupled to the control terminal of the third transistor of the first conductivity type; and
a first feedback transistor of the second conductivity type comprising a control terminal coupled to the control terminal of the third transistor of the second conductivity type.

5. The amplifier circuit of claim 4,
wherein the feedback circuit comprises a keeper circuit coupled to the third transistor of the first conductivity type and the first feedback transistor of the first conductivity type, the keeper circuit is configured to cause a drain-source voltage of the third transistor of the first conductivity type to be between a third upper voltage level and a third lower voltage level.

6. The amplifier circuit of any one of claims 1 to 5,
wherein the plurality of transistors comprises:
a fourth transistor of the first conductivity type coupled to the first transistor of the first conductivity type and the third transistor of the first conductivity type, the fourth transistor of the first conductivity type comprising a gate terminal configured to receive a first DC signal at the first lower voltage level.

7. The amplifier circuit of any one of claims 1 to 6,
wherein a first gate signal received by the gate terminal of the third transistor of the first conductivity type varies between the first lower voltage level and a voltage level that is greater than the second upper voltage level.

8. The amplifier circuit of claim 7,
wherein the first gate signal and the output signal are in phase.

9. The amplifier circuit of any one of claims 1 to 8,
wherein the feedback circuit being a first capacitive divider feedback circuit;
wherein the amplifier circuit further comprises a second capacitive divider feedback circuit coupled to the gate terminal of the second transistor of the first conductivity type and the gate terminal of the second transistor of the second conductivity type.

10. The amplifier circuit of claim 9,
wherein the output signal is based on a feedback capacitive ratio defined by the second capacitive divider feedback circuit.

11. The amplifier circuit of any one of claims 1 to 10,
wherein the plurality of transistors comprises:
one or more further transistors of the first conductivity type coupled to the first transistor of the first conductivity type and the second transistor of the first conductivity type;
one or more further transistors of the second conductivity type coupled to the first transistor of the second conductivity type and the second transistor of the second conductivity type.

12. The amplifier circuit of claim 11,
further comprising one or more further capacitive divider feedback circuits, each further capacitive divider feedback circuit is configured for a pair of the one or more further transistors of the first conductivity type and the one or more further transistors of the second conductivity type.

13. The amplifier circuit of any one of claims 1 to 12,
wherein each transistor of the plurality of transistors is configured to operate with a maximum operation voltage that is equal or smaller than a voltage represented by the peak-to-peak amplitude of the first signal or the second signal.

14. The amplifier circuit of any one of claims 1 to 13,
wherein the amplifier circuit is an amplifier circuit in an N-level stacking configuration, wherein N is an integer greater than 3.

15. The amplifier circuit of any one of claims 1 to 14,
wherein the transistors of the first conductivity type are p-type transistors and the transistors of the second conductivity type are n-type transistors.
